# EUROPEAN PATENT APPLICATION

(11) **EP 4 513 472 A1**
(43) Date of publication of application: **26.02.2025**
(21) Application number: 24188758.7
(22) Date of filing: 16.07.2024
(51) Int. Cl.: G09G 3/00

(54) **TEST PANEL AND DISPLAY DEVICE**

(30) Priority: 21.08.2023 KR 20230108972
(71) Applicant: Samsung Display Co., Ltd., Gyeonggi-do 17113 (KR)
(72) Inventor: KANG, Younggu, Giheung-Gu, Yongin-si, Gyeonggi-Do (KR); PARK, Hyeon-Do, Giheung-Gu, Yongin-si, Gyeonggi-Do (KR); PARK, Hyun-Sung, Giheung-Gu, Yongin-si, Gyeonggi-Do (KR); SEO, Yu Deok, Giheung-Gu, Yongin-si, Gyeonggi-Do (KR)
(74) Representative: Dr. Weitzel & Partner

(57) **Abstract**

A test panel includes: a pixel; a first test element connected to the pixel, the first test element including a gate electrode, a semiconductor layer, a first electrode, and a second electrode connected to the pixel; a test pad spaced apart from the first test element; a first connecting line connected to the first test element and the test pad; and a first resistive layer in a same layer as the semiconductor layer and connecting the first electrode and the first connecting line spaced apart from each other.

## Description

### BACKGROUND

### 1. Field

Aspects of some embodiments of the present invention described herein relate to a test panel and a display device.

### 2. Description of the Related Art

In general, a display device includes a display panel for displaying images and a driver connected to the display panel. The display panel includes a plurality of pixels for displaying images. The pixels are driven by a drive signal and generate light for displaying images.

Whether the pixels are operating normally may be tested after the display panel is manufactured. The display panel may include a plurality of test elements connected to the pixels to test the pixels. A test signal may be applied to the pixels through the test elements, and whether the pixels are operating normally may be examined by determining whether the pixels are turned on.

The test elements may be removed from the display panel after the pixels are completely tested. For example, the test elements may be located in a cutting region of the display panel, and the cutting region may be cut and removed after the pixels are completely tested.

When external static electricity is applied to the test elements, the test elements may be damaged, and therefore a normal test operation may not be performed.

The above information disclosed in this Background section is only for enhancement of understanding of the background and therefore the information discussed in this Background section does not necessarily constitute prior art.

### SUMMARY

The invention is defined by claim 1. Aspects of the present invention relate to a test panel for protecting test elements from static electricity.

Aspects of some embodiments of the present invention include a test panel for protecting first test elements from static electricity and a display device including a test panel from which a test element may be removed.

According to the invention, a test panel includes a pixel, a first test element that is connected to the pixel and that includes a gate electrode, a semiconductor layer, a first electrode, and a second electrode connected to the pixel, a test pad spaced apart from the first test element, a first connecting line connected to the first test element and the test pad, and a first resistive layer that is in a same layer as the semiconductor layer and that connects the first electrode and the first connecting line spaced apart from each other.

According to some embodiments, a test panel includes a pixel, a first test element that is connected to the pixel and that includes a gate electrode, a semiconductor layer, a first electrode, and a second electrode connected to the pixel, a test pad spaced apart from the first test element, a first connecting line between the first test element and the test pad, a first resistive layer that connects the first electrode and the first connecting line, and a second resistive layer that connects the first connecting line and the test pad. According to some embodiments, the first and second resistive layers are in a same layer as the semiconductor layer.

According to some embodiments, a display device includes a pixel including a transistor and a light emitting element connected to the transistor, a test element, a connecting line connected to the pixel and the test element, a connecting pad spaced apart from the test element and defined at one end of the connecting line, and a resistive layer connected to the connecting pad. According to some embodiments, the resistive layer is formed of a same material as a semiconductor layer of the transistor and in a same layer as the semiconductor layer of the transistor.

### BRIEF DESCRIPTION OF THE DRAWINGS

The above and other aspects and features of embodiments according to the present invention will become more apparent by describing in more detail aspects of some embodiments thereof with reference to the accompanying drawings.
FIG. 1 is a plan view of a test panel according to some embodiments of the present invention.
FIG. 2 is a view illustrating a data driver connected to the test panel after a second part illustrated in FIG. 1 is removed.
FIG. 3 is a sectional view of a display panel illustrated in FIG. 2 according to some embodiments.
FIG. 4 is a sectional view of one of pixels illustrated in FIG. 1 according to some embodiments.
FIG. 5 is a view illustrating a circuit configuration of first and second test units illustrated in FIG. 1 according to some embodiments.
FIG. 6 is an enlarged view of a first region AA1 illustrated in FIG. 1, where FIG. 6 illustrates a planar configuration of first test elements illustrated in FIG. 5 according to some embodiments.
FIG. 7 is an enlarged view of a second region AA2 illustrated in FIG. 1, where FIG. 7 illustrates a planar configuration of test pads illustrated in FIG. 5 according to some embodiments.
FIG. 8 is a sectional view taken along the line I-I' illustrated in FIG. 6 according to some embodiments.
FIG. 9 is a sectional view taken along the line II-II' illustrated in FIG. 7 according to some embodiments.
FIG. 10 is an enlarged view of a third region AA3 illustrated in FIG. 1, where FIG. 10 illustrates a planar configuration of connecting pads illustrated in FIG. 5 according to some embodiments.
FIG. 11 is a sectional view taken along the line III-III' illustrated in FIG. 10 according to some embodiments.
FIGS. 12 and 13 are views illustrating a configuration of first resistive layers according to some embodiments of the present invention.
FIGS. 14 and 15 are views illustrating a configuration of second resistive layers according to some embodiments of the present invention.
FIG. 16 illustrates test results on electric fields formed on semiconductor layers of first test elements when static electricity is applied to test pads in test panels including resistive layers illustrated in FIGS. 6, 7, 12, and 15 according to some embodiments.
FIG. 17 is a view illustrating antistatic circuits connected to first connecting lines according to some embodiments of the present invention.
FIG. 18 is an enlarged view of the antistatic circuit illustrated in FIG. 17 according to some embodiments.
FIG. 19 is a view illustrating antistatic circuits connected to first connecting lines according to some embodiments of the present invention.
FIG. 20 illustrates test results on electric fields formed on semiconductor layers of first test elements when static electricity is applied to test pads in test panels including the antistatic circuits illustrated in FIGS. 17 and 19 according to some embodiments.
FIG. 21 is a view illustrating a structure in which first and second resistors formed by the first and second resistive layers illustrated in FIGS. 6 and 7 and the antistatic circuits illustrated in FIG. 17 are used together according to some embodiments.
FIG. 22 illustrates test results on electric fields formed on semiconductor layers of first test elements when static electricity is applied to test pads in a test panel including the antistatic circuits and the first and second resistors illustrated in FIG. 21 according to some embodiments.
FIG. 23 is a view illustrating a configuration of third resistive layers according to some embodiments of the present invention.
FIG. 24 is a sectional view taken along the line IV-IV' illustrated in FIG. 23 according to some embodiments.
FIG. 25 is a view illustrating a configuration of fourth resistive layers according to some embodiments of the present invention.
FIG. 26 is a sectional view taken along the line V-V' illustrated in FIG. 25.
FIG. 27 is a view illustrating a configuration of connecting lines according to some embodiments of the present invention.
FIG. 28 is a sectional view taken along the line VI-VI' illustrated in FIG. 27 according to some embodiments.
FIG. 29 is a sectional view taken along the line VII-VII' illustrated in FIG. 27 according to some embodiments.
FIGS. 30 and 31 are views illustrating third connecting lines having a configuration different from that of third connecting lines illustrated in FIGS. 28 and 29 according to some embodiments.
FIG. 32 illustrates test results on electric fields formed on semiconductor layers of first test elements when static electricity is applied to connecting pads in a test panel including third connecting lines illustrated in FIGS. 28 and 29 according to some embodiments.
FIG. 33 is a view illustrating the display panel with the second part in FIG. 1 removed according to some embodiments.
FIG. 34 is a view illustrating a sectional configuration of a display device including the display panel illustrated in FIG. 33 according to some embodiments.

### DETAILED DESCRIPTION

In this specification, when it is mentioned that a component (or, an area, a layer, a part, etc.) is referred to as being "on", "connected to" or "coupled to" another component, this means that the component may be directly on, connected to, or coupled to the other component or a third component may be present therebetween.

Identical reference numerals refer to identical components. Additionally, in the drawings, the thicknesses, proportions, and dimensions of components are exaggerated for effective description.

As used herein, the term "and/or" includes all of one or more combinations defined by related components.

Terms such as first, second, and the like may be used to describe various components, but the components should not be limited by the terms. The terms may be used only for distinguishing one component from other components. For example, without departing the scope of the present invention, a first component may be referred to as a second component, and similarly, the second component may also be referred to as the first component. The terms of a singular form may include plural forms unless otherwise specified.

In addition, terms such as "below", "under", "above", and "over" are used to describe a relationship of components illustrated in the drawings. The terms are relative concepts and are described based on directions illustrated in the drawing.

Unless otherwise defined, all terms used herein, including technical or scientific terms, have the same meanings as those generally understood by those skilled in the art to which the present invention pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

It should be understood that terms such as "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

Hereinafter, aspects of some embodiments of the present invention will be described more fully with reference to the accompanying drawings.

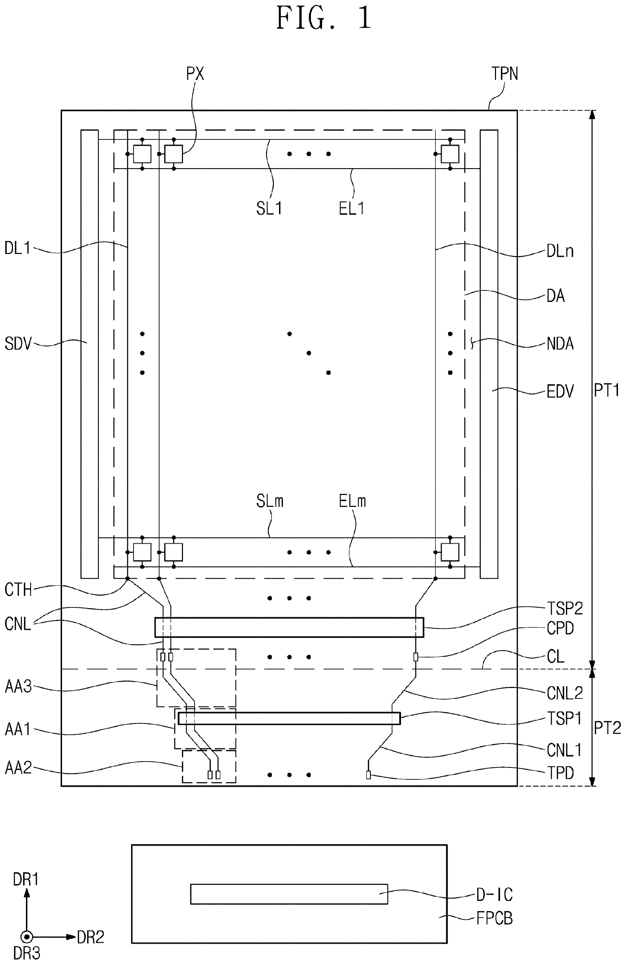

FIG. 1 is a plan view of a test panel according to some embodiments of the present invention.

Referring to FIG. 1, the test panel TPN may include a scan driver SDV, a light emission driver EDV, a plurality of pixels PX, a plurality of scan lines SL1 to SLm, a plurality of data lines DL1 to DLn, a plurality of light emission lines EL1 to ELm, a first test unit TSP1, a second test unit TSP2, a plurality of connecting lines CNL, a plurality of first connecting lines CNL1, a plurality of second connecting lines CNL2, a plurality of test pads TPD, and a plurality of connecting pads CPD. Here, "m" and "n" are natural numbers.

The test panel TPN may have a rectangular shape with long sides extending in a first direction DR1 and short sides extending in a second direction DR2 crossing the first direction DR1. However, the shape of the test panel TPN is not limited thereto.

Hereinafter, a direction perpendicular (or normal or substantially perpendicular) to a plane defined by the first direction DR1 and the second direction DR2 is defined as a third direction DR3. As used herein, the expression "when viewed from above the plane" or "in a plan view" may mean that it is viewed from the third direction DR3.

The test panel TPN may include a first part PT1 and a second part PT2 extending from the first part PT1 in the direction opposite to the first direction DR1. A cutting line CL may be defined at the boundary between the first part PT1 and the second part PT2. In a plan view, the first part PT1 may include a display region DA and a non-display region NDA surrounding (e.g., in a periphery or outside a footprint of) the display region DA.

The pixels PX may be located in the display region DA. The scan driver SDV and the light emission driver EDV may be located in the non-display regions NDA adjacent to edges of the first part PT1 that extend parallel to other in the first direction DR1.

The scan lines SL1 to SLm may extend in the second direction DR2 and may be connected to the pixels PX and the scan driver SDV. The data lines DL1 to DLn may extend in the first direction DR1 in the display region DA and may be connected to the pixels PX. The light emission lines EL1 to ELm may extend in the direction opposite to the second direction DR2 and may be connected to the pixels PX and the light emission driver EDV.

The first test unit TSP1 and the test pads TPD may be located on the second part PT2. The first test unit TSP1 and the test pads TPD may be spaced apart from each other in the first direction DR1. The test pads TPD may be arranged along the second direction DR2.

The first connecting lines CNL1 may be located between the first test unit TSP1 and the test pads TPD and may be connected to the first test unit TSP1 and the test pads TPD. The first connecting lines CNL1 may be connected to the test pads TPD, respectively.

The first connecting lines CNL1 may extend from the test pads TPD toward the first test unit TSP1, in particular the first connecting lines CNL1 may extend in the first direction DR 1 and/or second direction DR2, wherein a plurality of connecting lines CNL1 may be arranged in the second direction DR2. The first connecting lines CNL1 may be connected to first test elements of the first test unit TSP1. This configuration will be described below in more detail.

The first connecting lines CNL1 may extend from the test pads TPD in the first direction DR1 and may obliquely extend to form a certain inclined angle with respect to the first direction DR1. Thereafter, the first connecting lines CNL1 may extend in the first direction DR1 and may be connected to the first test unit TSP1.

The second test unit TSP2 and the connecting pads CPD may be located on the first part PT1. The second test unit TSP2 and the connecting pads CPD may be spaced apart from each other in the first direction DR1. The second test unit TSP2 and the connecting pads CPD may be located in the non-display region NDA adjacent to the boundary between the first part PT1 and the second part PT2.

The connecting pads CPD may be closer to the boundary between the first part PT1 and the second part PT2 than the second test unit TSP2. The connecting pads CPD may be arranged between the second test unit TSP2 and the first test unit TSP1. The second test unit TSP2 may be located between the connecting pads CPD and the display region DA. The connecting pads CPD may be arranged in the second direction DR2.

The second connecting lines CNL2 may be located between the first test unit TSP1 and the connecting pads CPD and may be connected to the first test unit TSP1 and the connecting pads CPD. The second connecting lines CNL2 may be connected to the connecting pads CPD, respectively.

The second connecting lines CNL2 may extend from the first test unit TSP1 toward the connecting pads CPD and may be arranged in the second direction DR2. The second connecting lines CNL2 may be connected to the first test elements of the first test unit TSP1. This configuration will be described below in detail.

The second connecting lines CNL2 may be connected to the first test unit TSP1 on the second part PT2, may extend toward the first part PT1, and may be connected to the connecting pads CPD on the first part PT1. The second connecting lines CNL2 may extend from the first test unit TSP1 in the first direction DR1 and may obliquely extend to form a certain inclined angle with respect to the first direction DR1. Thereafter, the second connecting lines CNL2 may extend in the first direction DR1 and may be connected to the connecting pads CPD.

The connecting lines CNL may be connected to the connecting pads CPD, respectively, and may extend from the connecting pads CPD to the second test unit TSP2. The connecting lines CNL may extend toward the display region DA via the second test unit TSP2.

For example, portions of the connecting lines CNL that pass through the second test unit TSP2 are illustrated by dotted lines. The connecting lines CNL may be connected to second test elements of the second test unit TSP2. This configuration will be described below in detail.

The connecting lines CNL may extend toward the display region DA and may be connected to the data lines DL1 to DLn, respectively. Accordingly, the connecting lines CNL may be connected to the pixels PX through the data lines DL1 to DLn. The connecting pads CPD may be connected to the pixels PX through the connecting lines CNL and the data lines DL1 to DLn.

The connecting lines CNL may be connected to the data lines DL1 to DLn through contact holes CTH defined in an insulating layer that is located between the connecting lines CNL and the data lines DL1 to DLn.

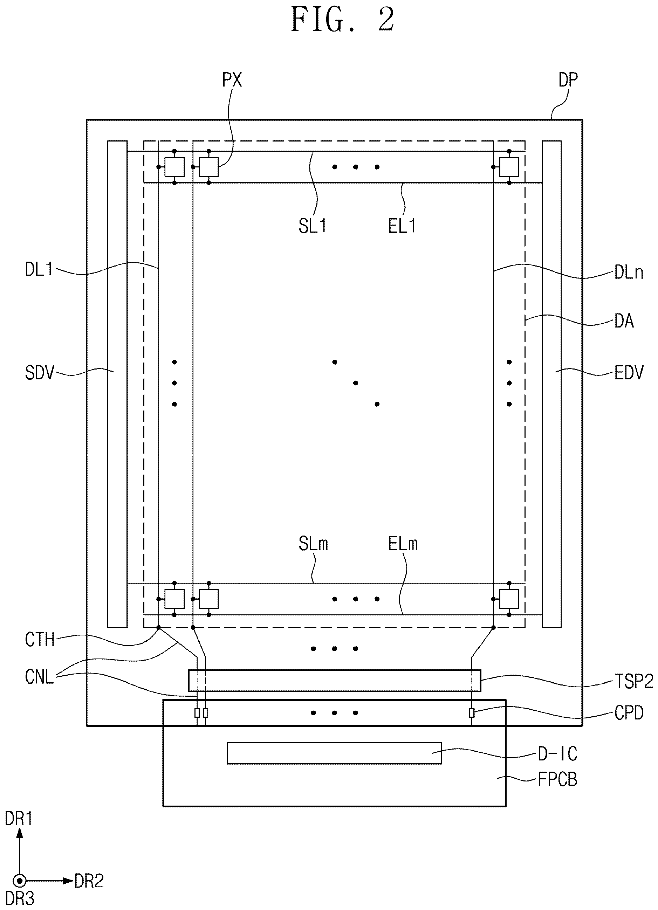

A data driver D-IC may be located adjacent to the test panel TPN. The data driver D-IC may be mounted on a flexible circuit board FPCB. A structure in which the data driver D-IC is connected to the test panel TPN will be described below with reference to FIG. 2.

According to some embodiments, power lines for supplying operating power to the pixels PX and control lines for applying control signals to the scan driver SDV and the light emission driver EDV may be additionally located in the test panel TPN.

Test signals may be applied to the pixels PX through the first test unit TSP1 to examine driving states of the pixels PX. In addition, test signals may be applied to the pixels PX through the second test unit TSP2 to additionally examine the driving states of the pixels PX.

According to some embodiments, a mother panel may be manufactured in a manufacturing process of a display device. The mother panel may include a plurality of test panels TPN. Each of the test panels TPN of the mother panel may include the first test unit TSP1 and the second test unit TSP2 described above.

In the mother panel, the driving states of pixels PX may be examined through the first test units TSP1. After the mother panel is manufactured, the test panels TPN may be cut from the mother panel and separated from one another. As a result, the test panel TPN illustrated in FIG. 1 may be formed. The second test unit TSP2 may be used to examine the driving states of the pixels PX in each of the test panels TPN separated from one another.

FIG. 2 is a view illustrating the data driver connected to the test panel after the second part illustrated in FIG. 1 is removed.

Referring to FIGS. 1 and 2, after the driving states of the pixels PX are examined, the test panel TPN may be cut along the cutting line CL, and the second part PT2 may be removed. The test panel TPN from which the second part PT2 is removed may be defined as a display panel DP. Hereinafter, the test panel TPN from which the second part PT2 is removed is referred to as the display panel DP.

The display panel DP according to some embodiments of the present invention may be an emissive display panel but embodiments according to the present invention are not limited thereto. For example, the display panel DP may be an organic light emitting display panel or a quantum-dot light emitting display panel. An emissive layer of the organic light emitting display panel may include an organic luminescent material. An emissive layer of the quantum-dot light emitting display panel may include quantum dots and quantum rods. Hereinafter, the display panel DP will be described in the context of an organic light emitting display panel, but embodiments according to the present invention are not limited thereto.

The flexible circuit board FPCB may be connected to the connecting pads CPD. The connecting pads CPD are located under the flexible circuit board FPCB. However, in FIG. 2, the connecting pads CPD are illustrated as being visible through the flexible circuit board FPCB.

The data driver D-IC may be connected to the connecting pads CPD through the flexible circuit board FPCB and may be connected to the display panel DP accordingly. According to some embodiments, the flexible circuit board FPCB may include lines connected to the data driver D-IC and pads connecting the lines to the connecting pads CPD. The data driver D-IC may be connected to the pixels PX through the connecting pads CPD, the connecting lines CNL, and the data lines DL1 to DLn.

When images are displayed on the display panel DP, the scan driver SDV, the data driver D-IC, and the pixels PX may be driven as follows.

The scan driver SDV may generate a plurality of scan signals, and the scan signals may be applied to the pixels PX through the scan lines SL1 to SLm. The data driver D-IC may generate a plurality of data voltages, and the data voltages may be applied to the pixels PX through the data lines DL1 to DLn. The light emission driver EDV may generate a plurality of light emission signals, and the light emission signals may be applied to the pixels PX through the light emission lines EL1 to ELm.

The pixels PX may receive the data voltages in response to the scan signals. The pixels PX may display images by emitting light having luminance corresponding to the data voltages in response to the light emission signals.

The second test unit TSP2 may remain in the display panel DP after the cutting process. However, the second test unit TSP2 may be turned off when the display panel DP displays an image. The second test unit TSP2 may remain in the turned-off state and thus may not affect the image display operation of the display panel DP.

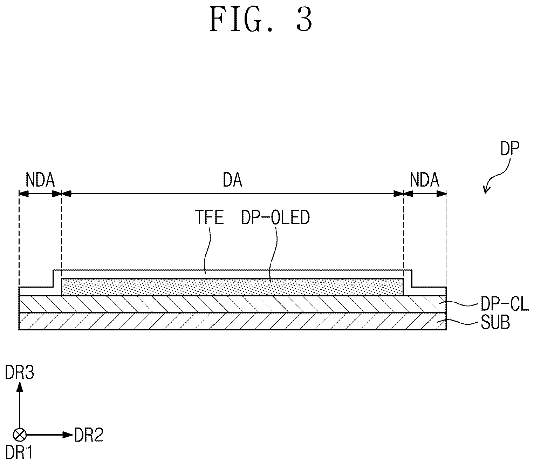

FIG. 3 is a sectional view of the display panel illustrated in FIG. 2.

In FIG. 3, a section of the display panel DP viewed in the first direction DR1 is illustrated.

Referring to FIG. 3, the display panel DP may include a substrate SUB, a circuit element layer DP-CL located on the substrate SUB, a display element layer DP-OLED located on the circuit element layer DP-CL, and a thin film encapsulation layer TFE located on the display element layer DP-OLED.

The substrate SUB may include a display region DA and a non-display region NDA around the display region DA. The substrate SUB may include a flexible plastic material, such as polyimide (PI), or glass. The display element layer DP-OLED may be located on the display region DA.

The plurality of pixels PX may be located in the circuit element layer DP-CL and the display element layer DP-OLED. Each of the pixels PX may include transistors located in the circuit element layer DP-CL and a light emitting element located in the display element layer DP-OLED and connected to the transistors.

The thin film encapsulation layer TFE may be located on the circuit element layer DP-CL and on the display element layer DP-OLED to cover the display element layer DP-OLED, in particular also side surfaces of the display element layer DP-OLED. The thin film encapsulation layer TFE may protect the pixels PX from moisture, oxygen, and external foreign matter.

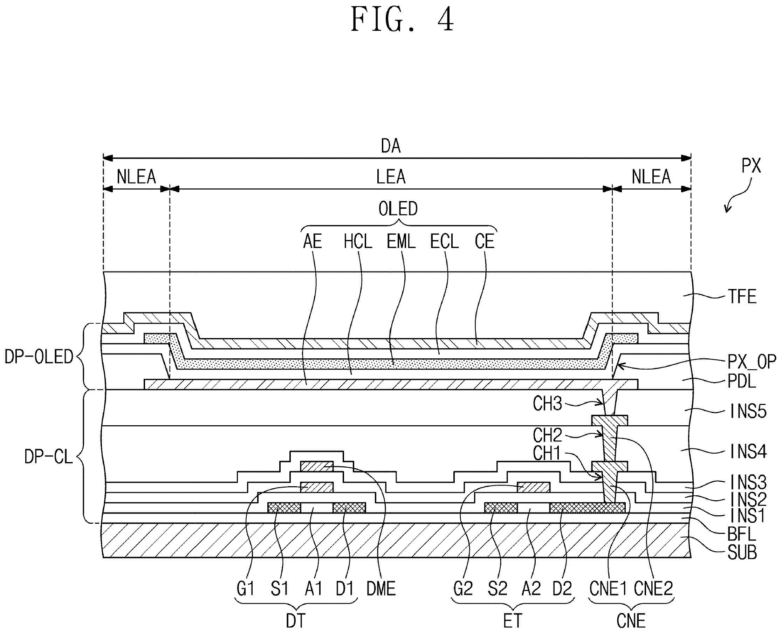

FIG. 4 is a sectional view of one of the pixels illustrated in FIG. 1.

Referring to FIG. 4, the pixel PX may include transistors DT and ET and a light emitting element OLED arranged over the transistors DT and ET. The transistors DT and ET may be located in the circuit element layer DP-CL, and the light emitting element OLED may be located in the display element layer DP-OLED.

The transistors DT and ET may include the drive transistor DT and the light emission transistor ET. Although the two transistors DT and ET are illustrated as an example, the pixel PX may include more transistors.

The drive transistor DT and the light emission transistor ET may be located on the substrate SUB. The display region DA may include an emissive region LEA corresponding to the pixel PX and a non-emissive region NLEA adjacent to the emissive region LEA. The light emitting element OLED may be located in the emissive region LEA.

A buffer layer BFL may be located on the substrate SUB. The buffer layer BFL may be an inorganic layer. A semiconductor layer S1, A1, and D1 of the drive transistor DT and a semiconductor layer S2, A2, and D2 of the light emission transistor ET may be located on the buffer layer BFL. The semiconductor layers S1, A1, D1, S2, A2, and D2 may include poly silicon. However, without being limited thereto, the semiconductor layers S1, A1, D1, S2, A2, and D2 may include amorphous silicon.

The semiconductor layers S1, A1, D1, S2, A2, and D2 may be doped with an N-type dopant or a P-type dopant. Each of the semiconductor layers S1, A1, D1, S2, A2, and D2 may include a heavily doped region and a lightly doped region. The heavily doped regions (e.g., source regions and drain regions) may have higher conductivity than the lightly doped regions and may substantially serve as source electrodes and drain electrodes of the drive and light emission transistors DT and ET. The lightly doped regions may correspond (or substantially correspond) to channel regions (or, channels) of the drive and light emission transistors DT and ET.

The first source region S1, the first channel region A1, and the first drain region D1 of the drive transistor DT may be formed from the semiconductor layer S1, A1, and D1. The second source region S2, the second channel region A2, and the second drain region D2 of the light emission transistor ET may be formed from the semiconductor layer S2, A2, and D2. The first channel region A1 may be located between the first source region S1 and the first drain region D1. The second channel region A2 may be located between the second source region S2 and the second drain region D2.

A first insulating layer INS1 may be located on the buffer layer BFL to cover the semiconductor layers S1, A1, D1, S2, A2, and D2. First and second gate electrodes G1 and G2 (or, control electrodes) of the drive and light emission transistors DT and ET may be located on the first insulating layer INS1. The semiconductor layers S1, A1, D1, S2, A2, and D2 may be located in a same layer, in particular directly above the buffer layer BFL. The first insulating layer INS1 may cover the buffer layer BFL and the semiconductor layers S1, A1, D1, S2, A2, and D2.

The first and second gate electrodes G1 and G2 may be located above the semiconductor layers S1, A1, D1, S2, A2, and D2. In particular, the first and second gate electrodes G1 and G2 may be located above the semiconductor layers A1 and A2, respectively. A second insulating layer INS2 may be located on the first insulating layer INS1 to cover the first and second gate electrodes G1 and G2. A dummy electrode DME may be located on the second insulating layer INS2. The dummy electrode DME may be arranged over the first gate electrode G1 and may overlap the first gate electrode G1 when viewed from above the plane. The dummy electrode DME may form a capacitor together with the first gate electrode G1.

A third insulating layer INS3 may be located on the second insulating layer INS2 to cover the dummy electrode DME. The buffer layer BFL and the first to third insulating layers INS1 to INS3 may include inorganic layers.

A connecting electrode CNE may be located between the light emission transistor ET and the light emitting element OLED. The connecting electrode CNE may electrically connect the light emission transistor ET and the light emitting element OLED. The connecting electrode CNE may include a first connecting electrode CNE1 and a second connecting electrode CNE2 located on the first connecting electrode CNE1.

The first connecting electrode CNE1 may be located on the third insulating layer INS3 and may be connected to the second drain region D2 through a first contact hole CH1 defined in the first to third insulating layers INS1 to INS3. A fourth insulating layer INS4 may be located on the third insulating layer INS3 to cover the first connecting electrode CNE1.

The second connecting electrode CNE2 may be located on the fourth insulating layer INS4. The second connecting electrode CNE2 may be connected to the first connecting electrode CNE1 through a second contact hole CH2 defined in the fourth insulating layer INS4. A fifth insulating layer INS5 may be located on the fourth insulating layer INS4 to cover the second connecting electrode CNE2. The fourth and fifth insulating layers INS4 and INS5 may include an inorganic layer or an organic layer.

The light emitting element OLED may be located on the fifth insulating layer INS5. The light emitting element OLED may include a first electrode AE, a second electrode CE, a hole control layer HCL, an electron control layer ECL, and an emissive layer EML. The first electrode AE may be an anode AE, and the second electrode CE may be a cathode CE.

The first electrode AE may be located on the fifth insulating layer INS5. The first electrode AE may be electrically connected to the second connecting electrode CNE2 through a third contact hole CH3 defined in the fifth insulating layer INS5.

A pixel defining layer PDL exposing a portion (e.g., a set or predetermined portion) of the first electrode AE may be located on the first electrode AE and the fifth insulating layer INS5. An opening PX-OP for exposing the portion (e.g., the set or predetermined portion) of the first electrode AE may be defined in the pixel defining layer PDL.

The hole control layer HCL may be located on the first electrode AE and the pixel defining layer PDL. The hole control layer HCL may be commonly arranged in the emissive region LEA and the non-emissive region NLEA. The hole control layer HCL may include a hole transport layer and a hole injection layer.

The emissive layer EML may be located on the hole control layer HCL. The emissive layer EML may be located in a region corresponding to the opening PX_OP. The emissive layer EML may include an organic material and/or an inorganic material. The emissive layer EML may generate one of red light, green light, and blue light.

The electron control layer ECL may be located on the emissive layer EML and the hole control layer HCL. The electron control layer ECL may be commonly located in the emissive region LEA and the non-emissive region NLEA. The electron control layer ECL may include an electron transport layer and an electron injection layer.

The second electrode CE may be located on the electron control layer ECL. The second electrode CE may be commonly located in the pixels PX. That is, the second electrode CE may be commonly arranged over the emissive layers EML of the pixels PX. The thin film encapsulation layer TFE may be located on the light emitting element OLED.

The layers from the buffer layer BFL to the fifth insulating layer INS5 may be defined as the circuit element layer DP-CL. The layer in which the light emitting element OLED is located may be defined as the display element layer DP-OLED.

A first voltage may be applied to the first electrode AE, and a second voltage having a lower voltage level than the first voltage may be applied to the second electrode CE. Holes and electrons injected into the emissive layer EML may be combined to form excitons, and the light emitting element OLED may emit light as the excitons transition to a ground state. An image may be displayed as the light emitting element OLED emits the light.

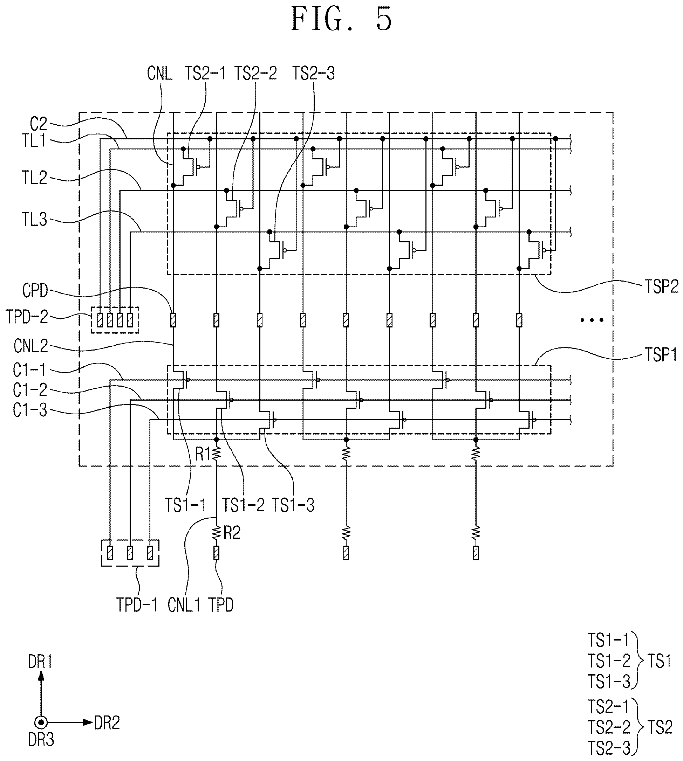

FIG. 5 is a view illustrating a circuit configuration of the first and second test units illustrated in FIG. 1.

In FIG. 5, the first and second connecting lines CNL1 and CNL2 are illustrated as extending in the first direction DR1.

Referring to FIGS. 1 and 5, the first test unit TSP1 may include a plurality of first test elements TS1. The first test elements TS1 may include PMOS transistors. However, without being limited thereto, the first test elements TS1 may include NMOS transistors.

The test pads TPD may be spaced apart from the first test elements TS1. The test pads TPD and the first test elements TS1 may be connected by the first connecting lines CNL1.

Each of the first test elements TS1 may include a source electrode, a drain electrode, and a gate electrode. Hereinafter, in FIG. 5, for convenience, one of the source electrode and the drain electrode is defined as a first electrode, and the other is defined as a second electrode. In addition, the gate electrode is defined as a control electrode.

The first test elements TS1 may include a plurality of first-first test elements TS1-1, a plurality of first-second test elements TS1-2, and a plurality of first-third test elements TS1-3. The first-first, first-second, and first-third test elements TS1-1, TS1-2, and TS1-3 may be repeatedly arranged in the second direction DR2 in the order of the first-first test element TS1-1, the first-second test element TS1-2, and the first-third test element TS1-3. The first-first, first-second, and first-third test elements TS1-1, TS1-2, and TS1-3 may be arranged shifted in the first direction DR1 in the order of the first-first test element TS1-1, the first-second test element TS1-2, and the first-third test element TS1-3.

The control electrodes of the first-first test elements TS1-1 may be commonly connected to a first-first control line C1-1. The control electrodes of the first-second test elements TS1-2 may be commonly connected to a first-second control line C1-2. The control electrodes of the first-third test elements TS1-3 may be commonly connected to a first-third control line C1-3.

The first-first control line C1-1, the first-second control line C1-2, and the first-third control line C1-3 may be connected to test pads TPD-1, respectively. According to some embodiments, the test panel TPN may include the first-first control line C1-1, the first-second control line C1-2, the first-third control line C1-3, and the test pads TPD-1.

The first electrodes of the first-first test element TS1-1, the first-second test element TS1-2, and the first-third test element TS1-3 sequentially adjacent to each other may be connected to a corresponding first connecting line CNL1 among the first connecting lines CNL1. That is, the first electrodes of the first-first test element TS1-1, the first-second test element TS1-2, and the first-third test element TS1-3 sequentially adjacent to each other may be commonly connected to the corresponding first connecting line CNL1.

The test panel TPN may include a plurality of first resistors R1 connected to the first test unit TSP1 and the first connecting lines CNL1 and a plurality of second resistors R2 connected to the first connecting lines CNL1 and the test pads TPD. The first resistors R1 and the second resistors R2 may be connected to opposite ends of the first connecting lines CNL1 that face away from each other in the first direction DR1.

The first resistors R1 may be located adjacent to the first test unit TSP1 and may be connected to first ends of the first connecting lines CNL1. The first electrodes of the first-first test element TS1-1, the first-second test element TS1-2, and the first-third test element TS1-3 sequentially adjacent to each other may be commonly connected to a corresponding first resistor R1 among the first resistors R1. A configuration of the first resistor R1 will be described below in detail.

The second resistors R2 may be located adjacent to the test pads TPD and may be connected to second ends of the first connecting lines CNL1. A configuration of the second resistor R2 will be described below in detail.

The second electrodes of the first-first, first-second, and first-third test elements TS1-1, TS1-2, and TS1-3 may be connected to the second connecting lines CNL2, respectively. The second electrodes of the first-first, first-second, and first-third test elements TS1-1, TS1-2, and TS1-3 may be connected to the connecting pads CPD through the second connecting lines CNL2, respectively. The connecting pads CPD may be connected to the connecting lines CNL, respectively.

As described above, the connecting lines CNL may be connected to the data lines DL1 to DLn, respectively. Accordingly, the first test elements TS1 may be connected to the pixels PX through the second connecting lines CNL2, the connecting pads CPD, the connecting lines CNL, and the data lines DL1 to DLn.

Control signals may be applied to the first-first, first-second, and first-third test elements TS1-1, TS1-2, and TS1-3 through the test pads TPD-1 and the first-first, first-second, and first-third control lines C1-1, C1-2, and C1-3. The control signals may be sequentially applied to the first-first control line C1-1, the first-second control line C1-2, and the first-third control line C1-3. Accordingly, the first-first test elements TS1-1, the first-second test elements TS1-2, and the first-third test elements TS1-3 may be sequentially turned on.

Test signals may be applied to the first-first, first-second, and first-third test elements TS1-1, TS1-2, and TS1-3 through the test pads TPD and the first connecting lines CNL1. The test signals may be provided to the second connecting lines CNL2 through the turned-on first-first test elements TS1-1, the turned-on first-second test elements TS1-2, and the turned-on first-third test elements TS1-3.

The test signals may be applied to the pixels PX through the second connecting lines CNL2, the connecting pads CPD, the connecting lines CNL, and the data lines DL1 to DLn. The pixels PX may be turned on in response to the test signals. The pixels PX may be turned on in response to the test signals, and a pixel PX that is not turned on or does not generate normal luminance may be determined as a defective pixel.

The first test elements TS1 may be vulnerable to external static electricity and may be damaged by the external static electricity. The external static electricity may flow into the first test elements TS1 through the test pads TPD. Static electricity may be defined as a rapid flow of current.

According to some embodiments of the present invention, the first and second resistors R1 and R2 may be located between the first test elements TS1 and the test pads TPD. The first and second resistors R1 and R2 may prevent or reduce static electricity by obstructing a rapid flow of current when the static electricity flows into the first test elements TS1 through the test pads TPD. As the first and second resistors R1 and R2 prevent or reduce the static electricity, damage to the first test elements TS1 may be prevented or reduced.

The second test unit TSP2 may include a plurality of second test elements TS2. The connecting pads CPD may be spaced apart from the second test elements TS2 in the first direction DR1. The second test elements TS2 may include PMOS transistors. However, without being limited thereto, the second test elements TS2 may include NMOS transistors.

The second test elements TS2 may include a plurality of second-first test elements TS2-1, a plurality of second-second test elements TS2-2, and a plurality of second-third test elements TS2-3. The second-first, second-second, and second-third test elements TS2-1, TS2-2, and TS2-3 may be repeatedly arranged in the second direction DR2 in the order of the second-first test element TS2-1, the second-second test element TS2-2, and the second-third test element TS2-3.

The second-first, second-second, and second-third test elements TS2-1, TS2-2, and TS2-3 may be commonly connected to a second control line C2. In other words, the second-first, second-second, and second-third test elements TS2-1, TS2-2, and TS2-3 may be each connected to the second control line C2. The first electrodes of the second-first test elements TS2-1 may be commonly connected to a first test line TL1. In other words, the first electrodes of the second-first test elements TS2-1 may be each connected to a first test line TL1. The first electrodes of the second-second test elements TS2-2 may be commonly connected to a second test line TL2. In other words, the first electrodes of the second-second test elements TS2-2 may be each connected to a second test line TL2. The first electrodes of the second-third test elements TS2-3 may be commonly connected to a third test line TL3. In other words, the first electrodes of the second-third test elements TS2-3 may be each connected to a third test line TL3.

The second control line C2 and the first, second, and third test lines TL1, TL2, and TL3 may be connected to test pads TPD-2, respectively. According to some embodiments, the test panel TPN may include the second control line C2, the first, second, and third test lines TL1, TL2, and TL3, and the test pads TPD-2.

The second electrodes of the second-first test elements TS2-1 may be connected to the connecting lines CNL connected to the first-first test elements TS1-1. The second electrodes of the second-second test elements TS2-2 may be connected to the connecting lines CNL connected to the first-second test elements TS1-2. The second electrodes of the second-third test elements TS2-3 may be connected to the connecting lines CNL connected to the first-third test elements TS1-3. Accordingly, the second test elements TS2 may be connected to the pixels PX through the connecting lines CNL and the data lines DL1 to DLn.

According to some embodiments, the pixels PX may include red pixels, green pixels, and blue pixels. The first-first test elements TS1-1 and the second-first test elements TS2-1 may be connected to the red pixels. The first-second test elements TS1-2 and the second-second test elements TS2-2 may be connected to the green pixels. The first-third test elements TS1-3 and the second-third test elements TS2-3 may be connected to the blue pixels.

The second-first, second-second, and second-third test elements TS2-1, TS2-2, and TS2-3 may be turned on by a control signal applied through the second control line C2. The second-first, second-second, and second-third test elements TS2-1, TS2-2, and TS2-3 may receive test signals through the first, second, and third test lines TL1, TL2, and TL3.

A test signal applied to the second-first test elements TS2-1 through the first test line TL1 may be applied to the above-described red pixels through the second-first test elements TS2-1. A test signal applied to the second-second test elements TS2-2 through the second test line TL2 may be applied to the above-described green pixels through the second-second test elements TS2-2. A test signal applied to the second-third test elements TS2-3 through the third test line TL3 may be applied to the above-described blue pixels through the second-third test elements TS2-3. Accordingly, whether the pixels PX are normally driven may be examined.

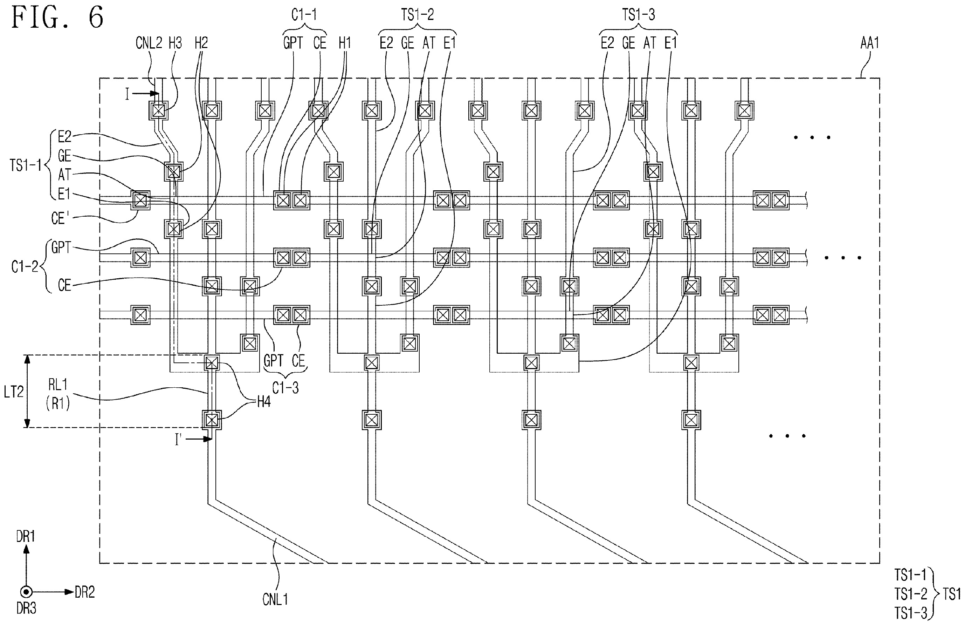

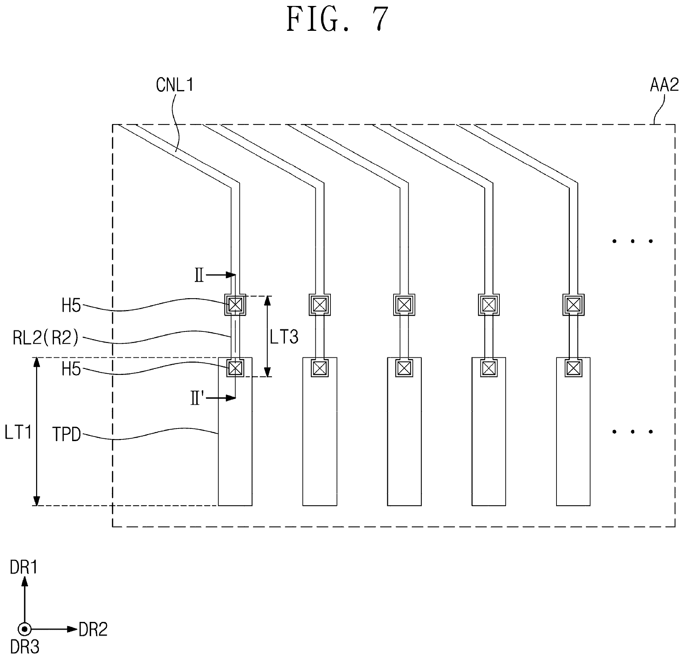

FIG. 6 is an enlarged view of a first region AA1 illustrated in FIG. 1, where FIG. 6 illustrates a planar configuration of the first test elements illustrated in FIG. 5. FIG. 7 is an enlarged view of a second region AA2 illustrated in FIG. 1, where FIG. 7 illustrates a planar configuration of the test pads illustrated in FIG. 5.

FIGS. 6 and 7 may be defined as layout drawings of the first test elements TS1 and the test pads TPD.

Referring to FIG. 6, each of the first-first, first-second, and first-third test elements TS1-1, TS1-2, and TS1-3 may include a gate electrode GE, a semiconductor layer AT, a first electrode E1, and a second electrode E2. The first-first, first-second, and first-third control lines C1-1, C1-2, and C1-3 may extend to cross the semiconductor layers AT of the first-first, first-second, and first-third test elements TS1 - 1, TS1-2, and TS1-3.

Because the first-first, first-second, and first-third test elements TS1 -1, TS1 - 2, and TS1-3, in particular all the first test elements TS1, have substantially the same configuration, only a configuration of one first-first test element TS1-1 will be mainly described below. Furthermore, because the first-first, first-second, and first-third control lines C1-1, C1-2, and C1-3 have substantially the same configuration, only a configuration of one first-first control line C1-1 will be described below.

The semiconductor layer AT of the first-first test element TS1 -1 may extend in the first direction DR1. The first-first control line C1-1 may include a plurality of gate patterns GPT that extend in the second direction DR2. The plurality of gate patterns GPT may be arranged in the second direction DR2 and connecting electrodes CE and CE' may connect the gate patterns GPT. In other words, the plurality of gate patterns GPT may be spaced apart from each other in the second direction DR2. The connecting electrodes CE and CE' may be connected to the gate patterns GPT through first contact holes H1.

The connecting electrode CE' connected to the leftmost gate pattern GPT may extend adjacent to the above-described test pad TPD and may define the above-described test pad TPD-1. Hereinafter, the gate pattern GPT crossing the semiconductor layer AT of the first-first test element TS1-1 will be described.

The gate pattern GPT may extend in the second direction DR2 to cross the semiconductor layer AT. A portion of the gate pattern GPT that overlaps the semiconductor layer AT may form the gate electrode GE of the first-first test element TS1-1.

The first electrode E1 and the second electrode E2 of the first-first test element TS1-1 may be spaced apart from each other in the first direction DR1 with the gate electrode GE of the first-first test element TS1-1 therebetween. The first electrode E1 and the second electrode E2 may be connected to the semiconductor layer AT through second contact holes H2.

The first electrodes E1 of the first-first test element TS1-1, the first-second test element TS1-2, and the first-third test element TS1-3 sequentially adjacent to each other may be integrally formed. The integrally formed first electrodes E1 may be connected to a corresponding first resistive layer RL1 among first resistive layers RL1. The first resistive layers RL1 may form the first resistors R1 illustrated in FIG. 5.

The second electrodes E2 of the first-first, first-second, and first-third test elements TS1-1, TS1-2, and TS1-3 may be connected to the second connecting lines CNL2, respectively. The second electrodes E2 may be connected to the second connecting lines CNL2 through third contact holes H3, respectively. Because the second connecting lines CNL2 are connected to the data lines DL1 to DLn as described above, the second electrodes E2 may be connected to the pixels PX, respectively.

Referring to FIGS. 6 and 7, the test pads TPD may be connected to second resistive layers RL2, respectively. The second resistive layers RL2 may form the second resistors R2 illustrated in FIG. 5.

Because the first resistive layers RL1 have the same configuration and the second resistive layers RL2 have the same configuration, a configuration of one first resistive layer RL1 and one first direction

RL2 connected to the first-first test element TS1-1 will be mainly described below. Furthermore, because the first connecting lines CNL1 have the same configuration and the test pads TPD have the same configuration, a configuration of one first connecting line CNL1 and one test pad TPD connected to the first-first test element TS1-1 will be mainly described below.

The first connecting line CNL1 may be connected, through the first resistive layer RL1 and the second resistive layer RL2, to the first-first test element TS1-1 and the test pad TPD spaced apart from each other. The first connecting line CNL1 may be located between the first-first test element TS1-1 and the test pad TPD. The first connecting line CNL1 may be spaced apart from the first electrode E1 of the first-first test element TS1-1. The first connecting line CNL1 may be spaced apart from the test pad TPD.

The first resistive layer RL1 may connect the first electrode E1 of the first-first test element TS1-1 and the first connecting line CNL1 spaced apart from each other. The first resistive layer RL1 may be connected to the first electrode E1 of the first-first test element TS1-1 and the first connecting line CNL1 through fourth contact holes H4.

One side of the first electrode E1 and one side of the first connecting line CNL1 may face each other. The first resistive layer RL1 may be connected to a portion of the first electrode E1 adjacent to the one side of the first electrode E1 and a portion of the first connecting line CNL1 adjacent to the one side of the first connecting line CNL1.

The second resistive layer RL2 may connect the first connecting line CNL1 and the test pad TPD spaced apart from each other. The second resistive layer RL2 may be connected to the first connecting line CNL1 and the test pad TPD through fifth contact holes H5.

An opposite side of the first connecting line CNL1 that faces away from the one side of the first connecting line CNL1 and one side of the test pad TPD may face each other. The second resistive layer RL2 may be connected to a portion of the first connecting line CNL1 adjacent to the opposite side of the first connecting line CNL1 and a portion of the test pad TPD adjacent to the one side of the test pad TPD.

The first resistive layer RL1, the second resistive layer RL2, and the test pad TPD may extend in the first direction DR1. The test pad TPD may have a first length LT1 in the first direction DR1. The first resistive layer RL1 may have a second length LT2 in the first direction DR1, and the second resistive layer RL2 may have a third length LT3 in the first direction DR1.

The second length LT2 and the third length LT3 may be equal to each other. However, without being limited thereto, the second length LT2 and the third length LT3 may be different from each other. Each of the second length LT2 and the third length LT3 may be set to 1/4 to 1/3 of the first length LT1. For example, the first length LT1 may be 100 micrometers (µm), and each of the second length LT2 and the third length LT3 may be 32.5 micrometers (µm).

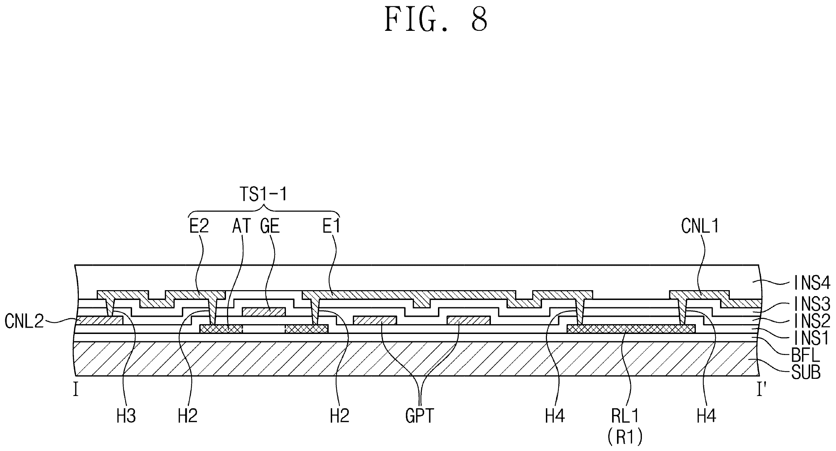

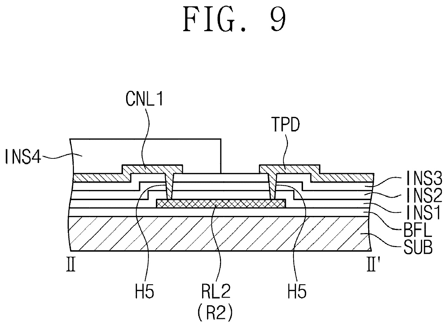

FIG. 8 is a sectional view taken along the line I-I' illustrated in FIG. 6. FIG. 9 is a sectional view taken along the line II-II' illustrated in FIG. 7.

Referring to FIG. 8, the first-first test element TS1-1 may include the gate electrode GE, the semiconductor layer AT, the first electrode E1, and the second electrode E2 that are located on the substrate SUB. The gate electrode GE and the semiconductor layer AT may have substantially the same configurations as the gate electrode G1 and the semiconductor layer S1, A1, and D1 illustrated in FIG. 4 and may be located in the same layer. The first and second electrodes E1 and E2 may have substantially the same configuration as the first connecting electrode CNE1 illustrated in FIG. 4 and may be located in the same layer.

The buffer layer BFL may be located on the substrate SUB. The semiconductor layer AT and the first resistive layer RL1 may be located on the buffer layer BFL. The first resistive layer RL1 may be located in the same layer as the semiconductor layer AT. The first resistive layer RL1 may include the same material as the semiconductor layer AT. The first resistive layer RL1 may be a semiconductor doped with impurities and may be defined as a conductor having high resistance.

The first insulating layer INS1 may be located on the buffer layer BFL to cover the semiconductor layer AT and the first resistive layer RL1. The gate electrode GE, the gate patterns GPT, and the second connecting line CNL2 may be located on the first insulating layer INS1. The gate electrode GE, the gate patterns GPT, and the second connecting line CNL2 may be located in the same layer. The semiconductor layer AT and the first resistive layer RL1 may be located in a layer below the gate electrode GE, the gate patterns GPT, and the second connecting line CNL2.

The second insulating layer INS2 may be located on the first insulating layer INS1 to cover the gate electrode GE, the gate patterns GPT, and the second connecting line CNL2. The third insulating layer INS3 may be located on the second insulating layer INS2.

The first electrode E1, the second electrode E2, and the first connecting line CNL1 may be located on the third insulating layer INS3. The first electrode E1, the second electrode E2, and the first connecting line CNL1 may be located in the same layer. The first electrode E1, the second electrode E2, and the first connecting line CNL1 may be located in a layer above the gate electrode GE.

The first and second electrodes E1 and E2 may be connected to the semiconductor layer AT through the second contact holes H2 defined in the first, second, and third insulating layers INS1, INS2, and INS3. The second electrode E2 may be connected to the second connecting line CNL2 through the third contact hole H3 defined in the second and third insulating layers INS2 and INS3. The first electrode E1 and the first connecting line CNL1 may be connected to the first resistive layer RL1 through the fourth contact holes H4 defined in the first, second, and third insulating layers INS1, INS2, and INS3.

According to some embodiments, the connecting electrodes CE illustrated in FIG. 6 may be located in the same layer as the first and second electrodes E1 and E2. Accordingly, the first contact holes H1 may be defined in the second and third insulating layers INS2 and INS3.

The fourth insulating layer INS4 may be located on the third insulating layer INS3 to cover the first electrode E1, the second electrode E2, and the first connecting line CNL1.

Referring to FIGS. 8 and 9, the second resistive layer RL2 may be located on the buffer layer BFL. The second resistive layer RL2 may be located in the same layer as the semiconductor layer AT and may include the same material as the semiconductor layer AT. The second resistive layer RL2 may be located in a layer below the gate electrode GE. The second resistive layer RL2 may be a semiconductor doped with impurities and may be defined as a conductor having high resistance.

The first connecting line CNL1 and the test pad TPD may be located on the third insulating layer INS3. The first connecting line CNL1 and the test pad TPD may be located in the same layer. The first connecting line CNL1 and the test pad TPD may be connected to the second resistive layer RL2 through the fifth contact holes H5 defined in the first, second, and third insulating layers INS1, INS2, and INS3.

The fourth insulating layer INS4 may be located on the first connecting line CNL1. The fourth insulating layer INS4 may not be located on the test pad TPD. The test pad TPD may be exposed to the outside.

Referring to FIGS. 6 to 9, the first and second resistive layers RL1 and RL2 may have high resistance and thus may prevent or reduce static electricity flowing into the first test elements TS1 through the test pads TPD. Accordingly, damage to the first test elements TS1 may be prevented or reduced by the first and second resistive layers RL1 and RL2.

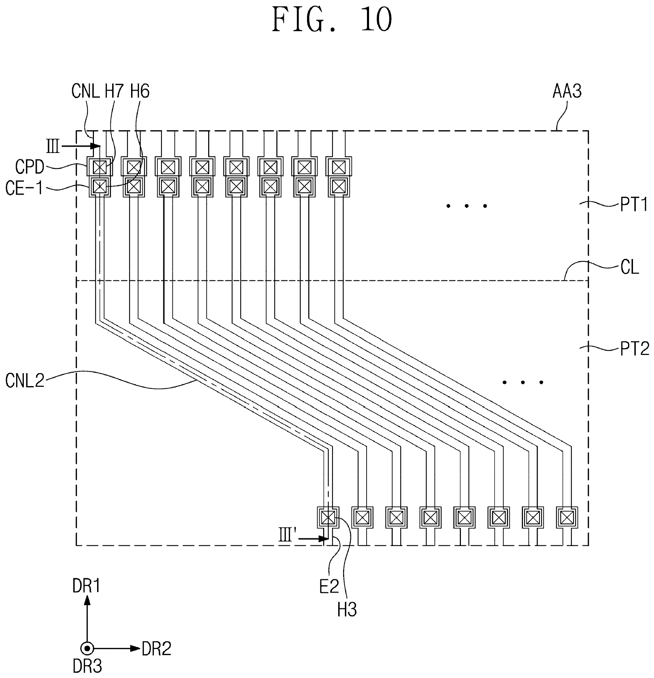

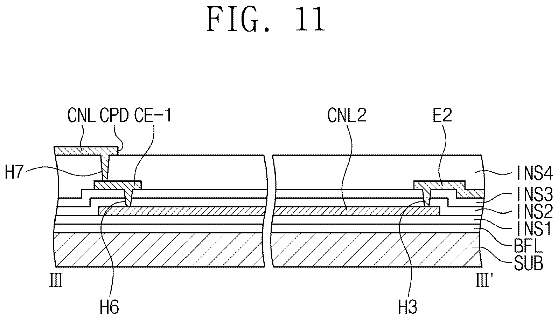

FIG. 10 is an enlarged view of a third region AA3 illustrated in FIG. 1, where FIG. 10 illustrates a planar configuration of the connecting pads illustrated in FIG. 5 FIG. 11 is a sectional view taken along the line III-III' illustrated in FIG. 10.

Referring to FIGS. 6 and 10, the connecting pads CPD may be spaced apart from the second electrodes E2. The second connecting lines CNL2 may be connected to the connecting pads CPD and the second electrodes E2. The second connecting lines CNL2 and the connecting pads CPD may be connected by connecting electrodes CE-1. The connecting lines CNL may extend from the connecting pads CPD, respectively, in the second direction DR2.

Hereinafter, a configuration of one second connecting line CNL2 and one connecting pad CPD connected to one connecting electrode CE-1 will be mainly described.

The connecting electrode CE-1 may be connected to the second connecting line CNL2 through a sixth contact hole H6. The connecting pad CPD may be connected to the connecting electrode CE-1 through a seventh contact hole H7.

Referring to FIGS. 10 and 11, the second connecting line CNL2 may be located on the first insulating layer INS1. The connecting electrode CE-1 may be located on the third insulating layer INS3. The connecting pad CPD and the connecting line CNL extending from the connecting pad CPD may be located on the fourth insulating layer INS4. The connecting pad CPD may be located in a layer above the second electrode E2 and the connecting electrode CE-1.

The connecting electrode CE-1 may be connected to the second connecting line CNL2 through the sixth contact hole H6 defined in the second and third insulating layers INS2 and INS3. The connecting pad CPD may be connected to the connecting electrode CE-1 through the seventh contact hole H7 defined in the fourth insulating layer INS4. The connecting pad CPD may be exposed to the outside and may be connected to the above-described flexible circuit board FPCB.

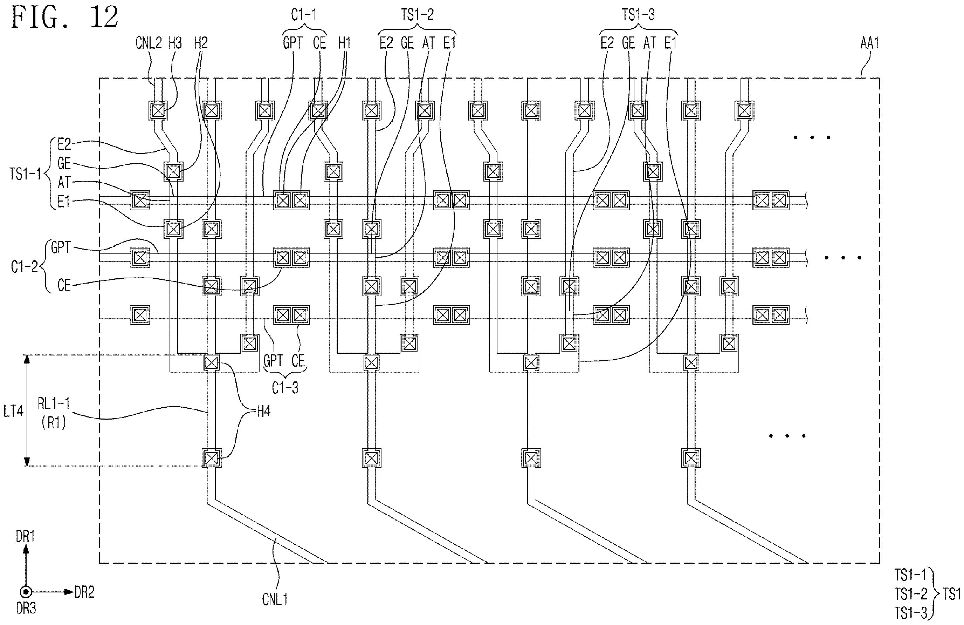

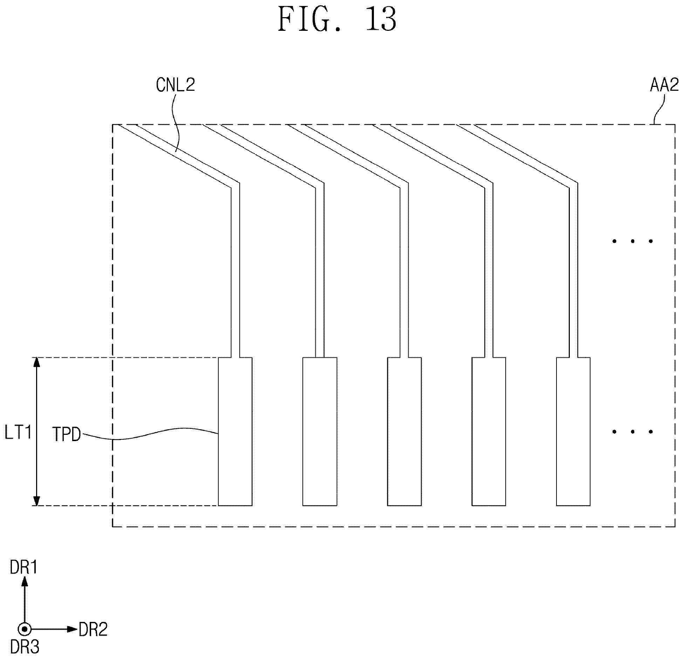

FIGS. 12 and 13 are views illustrating a configuration of first resistive layers according to some embodiments of the present invention.

FIGS. 12 and 13 are plan views corresponding to FIGS. 6 and 7. The following description will be focused on a difference between the components illustrated in FIGS. 6 and 7 and the components illustrated in FIGS. 12 and 13. Hereinafter, for convenience of description, a configuration of one first resistive layer RL1-1 will be mainly described.

Referring to FIGS. 12 and 13, the first resistive layer RL1-1 may connect the first-first test element TS1-1 and the first connecting line CNL1. The above-described first resistor R1 may be formed by the first resistive layer RL1-1. Unlike in the configuration illustrated in FIG. 7, the second resistive layer RL2 for connecting the test pad TPD and the first connecting line CNL1 may not be used.

The first resistive layer RL1-1 may have a fourth length LT4 in the first direction DR1. The fourth length LT4 may be set to 1/3 to 2/3 of the first length LT1. For example, the fourth length LT4 may be 65 micrometers (µm).

Although the second resistive layer RL2 illustrated in FIG. 7 is not used, embodiments of the present invention are not limited thereto. For example, the first resistive layers RL1-1 connected to the first test elements TS1 and the second resistive layers RL2 connected to the test pads TPD may be used together. In this case, the second resistive layers RL2 may be shorter than the first resistive layers RL1-1.

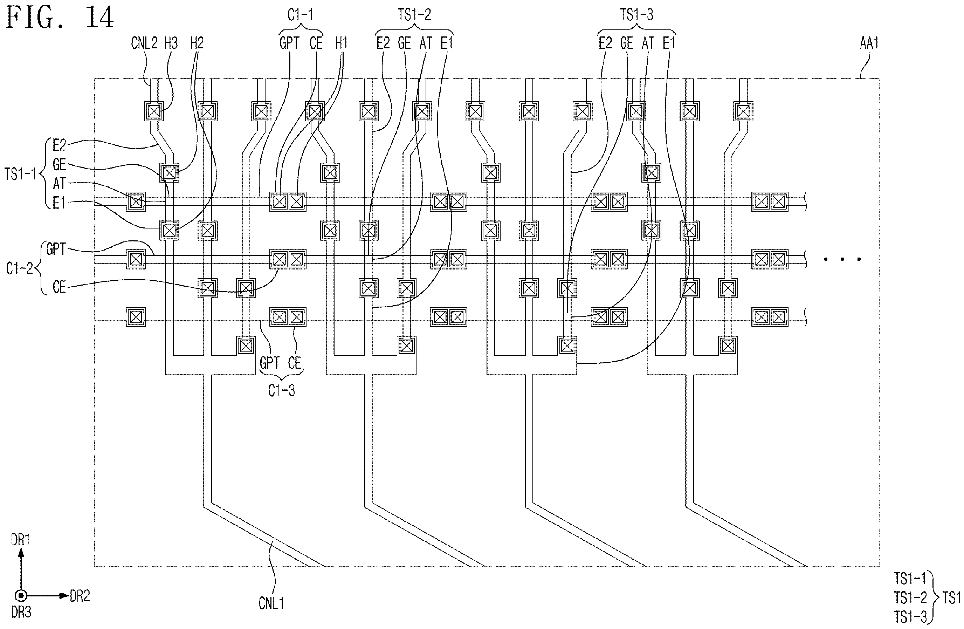

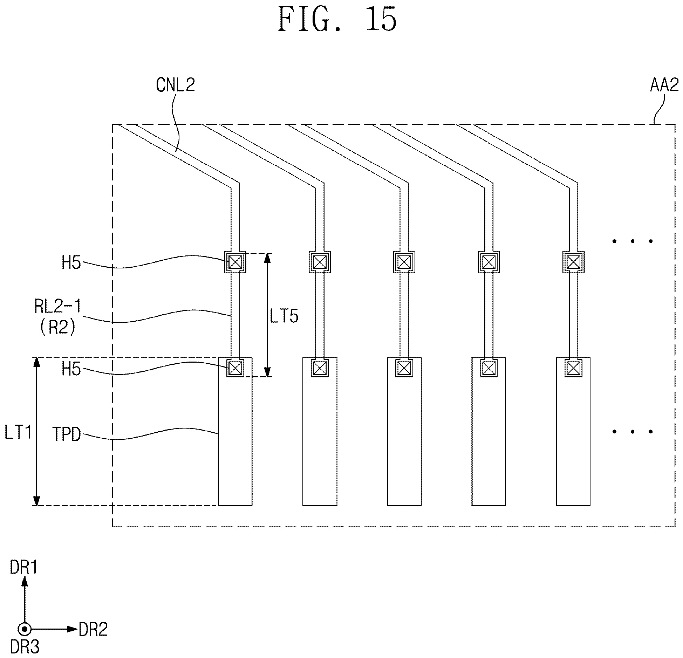

FIGS. 14 and 15 are views illustrating a configuration of second resistive layers according to some embodiments of the present invention.

FIGS. 14 and 15 are plan views corresponding to FIGS. 6 and 7. The following description will be focused on a difference between the components illustrated in FIGS. 6 and 7 and the components illustrated in FIGS. 14 and 15. Hereinafter, for convenience of description, a configuration of one second resistive layer RL2-1 will be mainly described.

Referring to FIGS. 14 and 15, the second resistive layer RL2-1 may connect the test pad TPD and the first connecting line CNL1. The above-described second resistor R2 may be formed by the second resistive layer RL2-1. Unlike in the configuration illustrated in FIG. 6, the first resistive layer RL1 for connecting the first-first test element TS1-1 and the first connecting line CNL1 may not be used.

The second resistive layer RL2-1 may have a fifth length LT5 in the first direction DR1. The fifth length LT5 may be set to 1/3 to 2/3 of the first length LT1. For example, the fifth length LT5 may be 65 micrometers (µm).

Although the first resistive layer RL1 illustrated in FIG. 6 is not used, embodiments of the present invention are not limited thereto. For example, the second resistive layers RL2-1 connected to the test pads TPD and the first resistive layers RL1 connected to the first test elements TS1 may be used together. In this case, the first resistive layers RL1 may be shorter than the second resistive layers RL2-1.

When the lengths of the first and second resistive layers RL1, RL2, RL1-1, and RL2-1 are too long, the resistance values may be too large, and therefore it may be difficult to transmit signals. According to some embodiments of the present invention, the lengths of the first and second resistive layers RL1, RL2, RL1-1, and RL2-1 may be set to 2/3 or less of the first length LT1. In this case, test signals may be normally transmitted, and static electricity may be prevented or reduced.

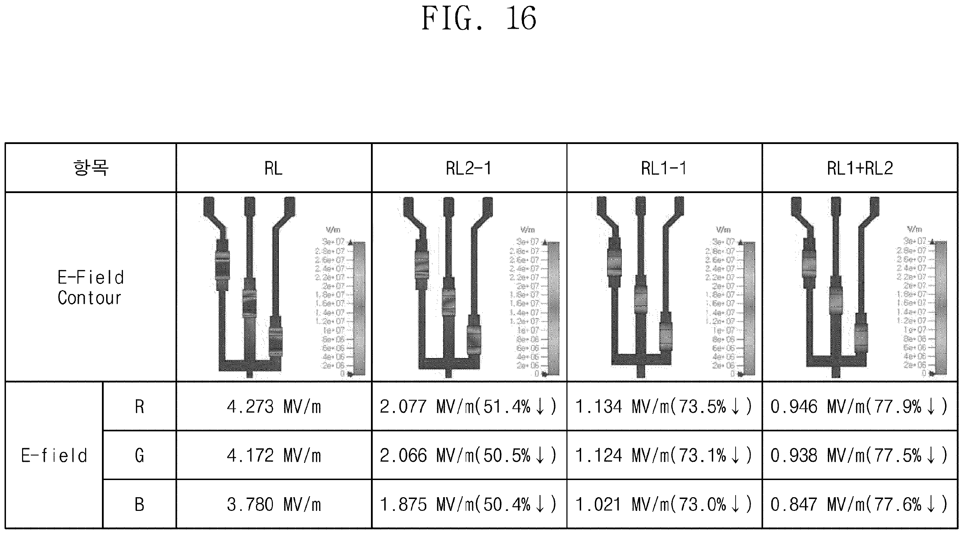

FIG. 16 illustrates test results on electric fields formed on semiconductor layers of first test elements when static electricity is applied to test pads in test panels including the resistive layers illustrated in FIGS. 6, 7, 12, and 15.

For example, the test was performed by applying static electricity to three first test elements TS1 connected to one test pad TPD. The three first test elements TS1 connected to the one test pad TPD may include a first-first test element TS1-1, a first-second test element TS1-2, and a first-third test element TS1-3. For convenience of description, the reference numerals of the first test elements TS1, in particular TS1 - 1, TS1-2, and TS1-3, are omitted in FIG. 16.

Referring to FIG. 16, the E-Field Contours in the drawing are pictures showing the outlines of the intensities of the electric fields in monochrome instead of in color. In the table, the intensities of the electric fields may be increased with an approach to red, and the intensities of the electric fields may be decreased with an approach to blue.

R, G, and B of E-Field in the drawing represent the values of intensities of the electric fields measured in the first-first test element TS1-1 connected to the red pixel R, the first-second test element TS1-2 connected to the green pixel G, and the first-third test element TS1-3 connected to the blue pixel B.

The comparative resistive layer RL may represent a resistive layer connected to the test pad TPD and the first connecting line CNL1, and the length of the comparative resistive layer RL may be 12 micrometers (µm). That is, the comparative resistive layer RL and the second resistive layer RL2 may be connected to the test pad TPD, but the comparative resistive layer RL may be shorter than the second resistive layer RL2.

The intensities of the electric fields formed in the first test elements TS1 depending on the comparative resistive layer RL, the second resistive layer RL2-1 illustrated in FIG. 15, the first resistive layer RL1-1 illustrated in FIG. 12, and the first and second resistive layers RL1+RL2 illustrated in FIGS. 6 and 7 when static electricity is applied through the test pads TPD are as shown in FIG. 16.

When the second resistive layer RL2-1 is used, the intensities of the electric fields may be further decreased, as compared with when the comparative resistive layer RL is used. When the first resistive layer RL1-1 is used, the intensities of the electric fields may be further decreased, as compared with when the second resistive layer RL2-1 is used. When the first and second resistive layers RL1+RL2 are used, the intensities of the electric fields may be further decreased, as compared with when the first resistive layer RL1-1 is used. Accordingly, when the first and second resistive layers RL1+RL2, the first resistive layer RL1-1, and the second resistive layer RL2-1 are used, static electricity may be effectively prevented or reduced.

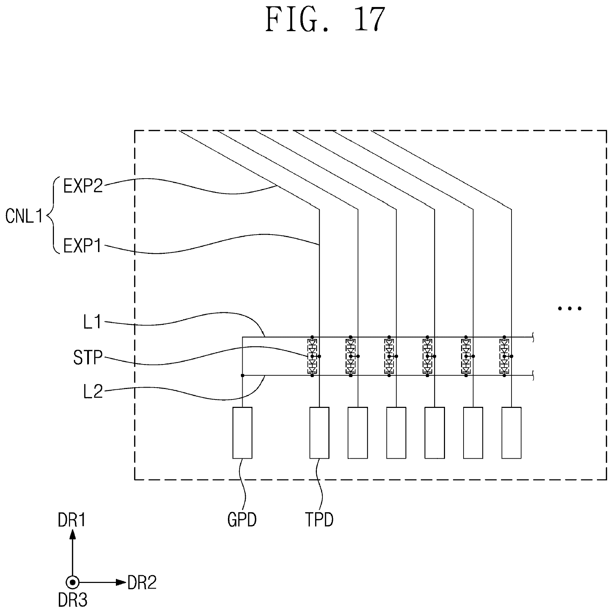

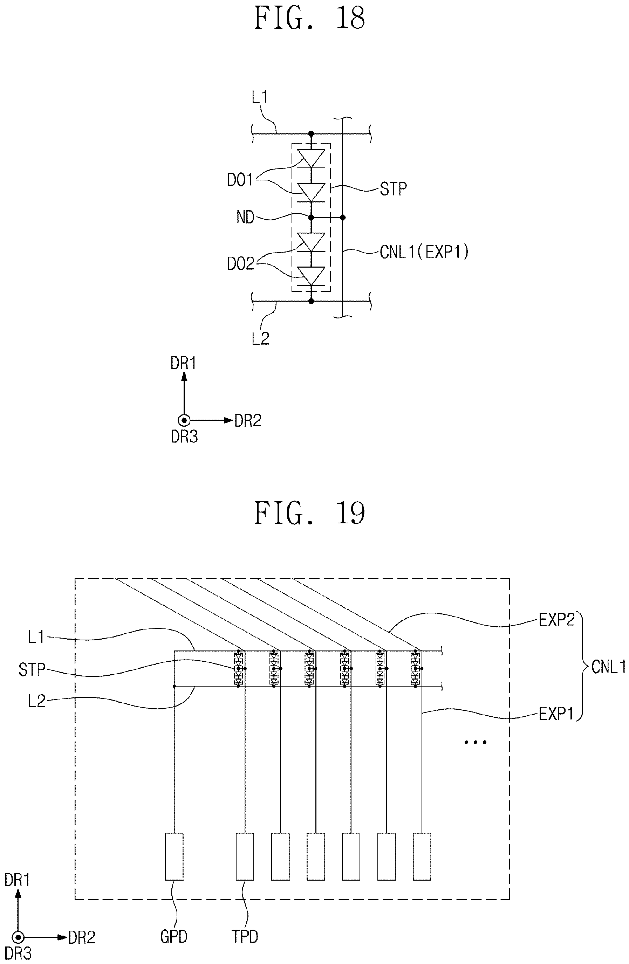

FIG. 17 is a view illustrating antistatic circuits connected to first connecting lines according to some embodiments of the present invention. FIG. 18 is an enlarged view of the antistatic circuit illustrated in FIG. 17.

Referring to FIGS. 17 and 18, the test panel TPN may further include the antistatic circuits STP. The antistatic circuits STP may be connected to the first connecting lines CNL1, respectively. One end of each of the antistatic circuits STP may be connected to a first line L1, and an opposite end of the antistatic circuit STP may be connected to a second line L2. The first and second lines L1 and L2 may be connected to a ground pad GPD. The antistatic circuits STP may be located adjacent to the test pads TPD, respectively.

Hereinafter, a configuration of one first connecting line CNL1 and one antistatic circuit STP connected to the one first connecting line CNL1 will be mainly described. The antistatic circuit STP may include a plurality of diodes DO1 and DO2 connected to a corresponding first connecting line CNL1 among the first connecting lines CNL1.

The diodes DO1 and DO2 of the antistatic circuit STP may include the first diodes DO1 and the second diodes DO2. The first diodes DO1 may be connected to the first line L1 and the first connecting line CNL1. The second diodes DO2 may be connected to the second line L2 and the first connecting line CNL1.

The first diodes DO1 may be connected to the first line L1 and a node ND. The first diodes DO1 may be arranged in a forward direction from the first line L1 toward the node ND and may be connected in series.

The second diodes DO2 may be connected to the second line L2 and the node ND. The second diodes DO2 may be arranged in a forward direction from the node ND toward the second line L2 and may be connected in series.

The node ND may be connected to the first connecting line CNL1. The first diodes DO1 may be connected to the first connecting line CNL1 through the node ND. The second diodes DO2 may be connected to the first connecting line CNL1 through the node ND.

The first connecting line CNL1 may include a first extension EXP1 extending from the test pad TPD in the first direction DR1 and a second extension EXP2 extending to form an obtuse angle with the first extension EXP1. The second extension EXP2 may extend toward the above-described first test element TS1. The antistatic circuit STP may be connected to the first extension EXP1 and may be located adjacent to a corresponding test pad TPD among the test pads TPD.

Static electricity applied through the test pads TPD may be distributed to the antistatic circuits STP and may be discharged through the ground pad GPD. Accordingly, damage to the first test elements TS1 due to static electricity may be prevented or reduced.

FIG. 19 is a view illustrating antistatic circuits connected to first connecting lines according to some embodiments of the present invention.

The following description will be focused on components different from the components illustrated in FIG. 17.

Referring to FIG. 19, the antistatic circuits STP may have the same configuration as the antistatic circuits STP illustrated in FIG. 17. The antistatic circuits STP may be connected to the first connecting lines CNL1, respectively. Unlike that illustrated in FIG. 17, each of the antistatic circuits STP may be located adjacent to a second extension EXP2 of a corresponding first connecting line CNL1.

Referring to FIGS. 17 and 19, according to some embodiments, the above-described first and second resistive layers RL1 and RL2 may be used together with the antistatic circuits STP. Alternatively, the first resistive layers RL1-1 or the second resistive layers RL2-1 described above may be used together with the antistatic circuits STP. In another case, the comparative resistive layer RL described with reference to FIG. 16 may also be used together with the antistatic circuits STP.

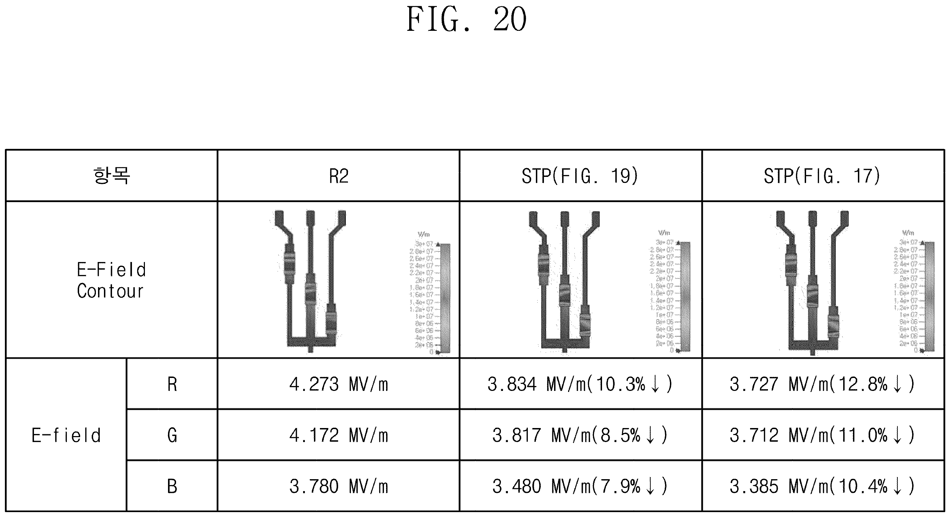

FIG. 20 illustrates test results on electric fields formed on semiconductor layers of first test elements when static electricity is applied to test pads in test panels including the antistatic circuits illustrated in FIGS. 17 and 19.

The items marked as STP in FIG. 20 may represent the intensities of electric fields when the comparative resistive layer RL illustrated in FIG. 16 and the antistatic circuits STP illustrated in FIGS. 17 and 19 are used together.

Referring to FIG. 20, when the antistatic circuit STP of FIG. 19 is additionally used, the intensities of the electric fields may be decreased, as compared with when the comparative resistive layer RL is used. Furthermore, when the antistatic circuit STP of FIG. 17 is additionally used, the intensities of the electric fields may be further decreased, as compared with when the comparative resistive layer RL is used.

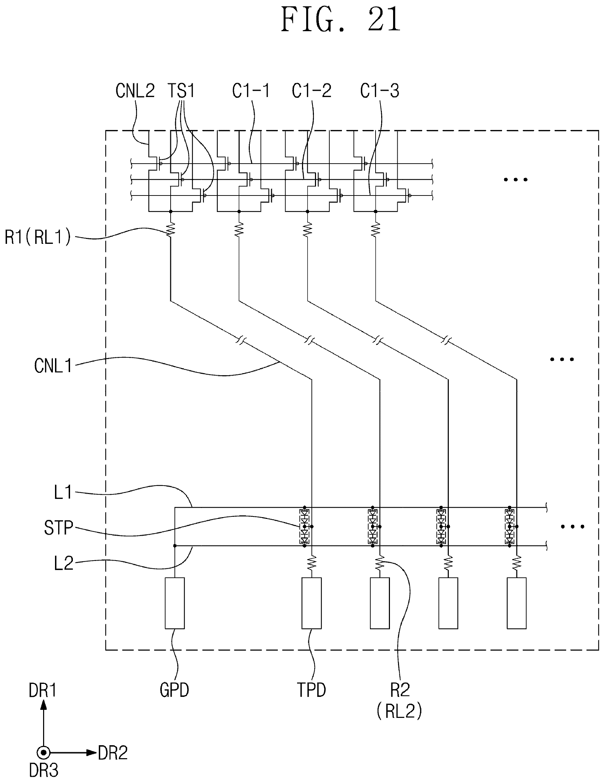

FIG. 21 is a view illustrating a structure in which the first and second resistors formed by the first and second resistive layers illustrated in FIGS. 6 and 7 and the antistatic circuits illustrated in FIG. 17 are used together.

In FIG. 21, the first test elements TS1, the first and second resistors R1 and R2, and the antistatic circuits STP are illustrated as a circuit structure.

Referring to FIG. 21, the antistatic circuits STP may be adjacent to the test pads TPD, respectively, and may be connected to the first connecting lines CNL1, respectively. The antistatic circuits STP may be located adjacent to the second resistive layers RL2, respectively. To further prevent or reduce static electricity, the antistatic circuits STP may be used together with the first and second resistors R1 and R2 formed by the first and second resistive layers RL1 and RL2.

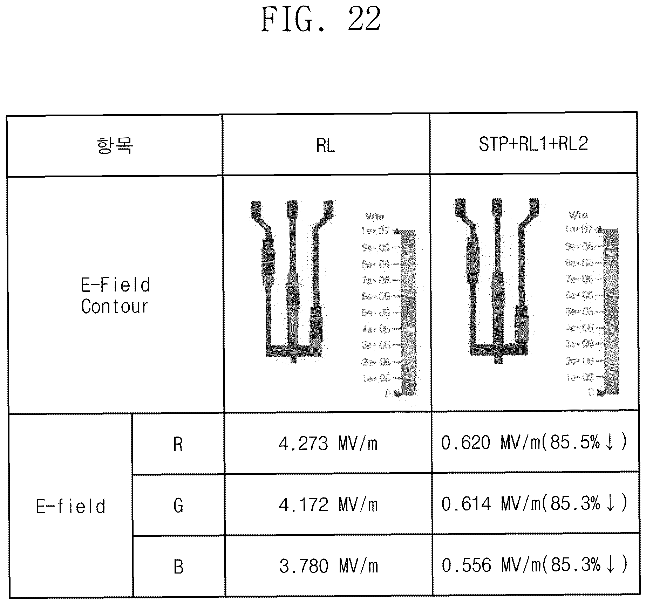

FIG. 22 illustrates test results on electric fields formed on semiconductor layers of first test elements when static electricity is applied to test pads in a test panel including the antistatic circuits and the first and second resistors illustrated in FIG. 21.

Referring to FIG. 22, when the first and second resistors RL1 and RL2 and the antistatic circuits STP of FIG. 21 are used, the intensities of the electric fields may be further decreased, as compared with when the comparative resistive layer RL is used.

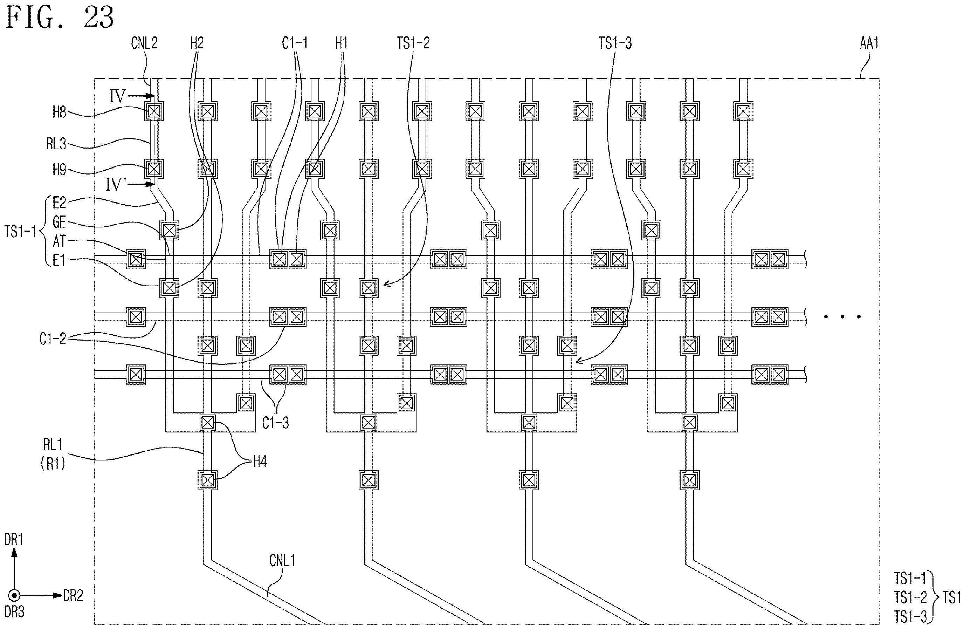

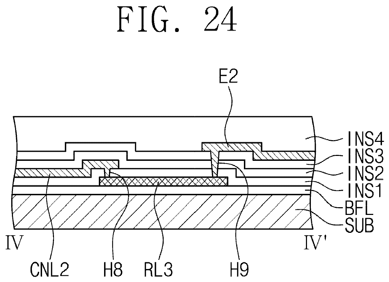

FIG. 23 is a view illustrating a configuration of third resistive layers according to some embodiments of the present invention. FIG. 24 is a sectional view taken along the line IV-IV' illustrated in FIG. 23.

FIG. 23 is a plan view corresponding to FIG. 6. The following description will be focused on components different from the components illustrated in FIG. 6.

Referring to FIG. 23, the test panel TPN may further include a plurality of third resistive layers RL3. The second connecting lines CNL2 may be spaced apart from the second electrodes E2 of the first test elements TS1. The third resistive layers RL3 may connect the second electrodes E2 and the second connecting lines CNL2 spaced apart from each other. The third resistive layers RL3 may be connected to the second electrodes E2 and the second connecting lines CNL2 through eighth and ninth contact holes H8 and H9.

Referring to FIG. 24, the third resistive layer RL3 may be located on the buffer layer BFL, the second connecting line CNL2 may be located on the first insulating layer INS1, and the second electrode E2 may be located on the third insulating layer INS3. The third resistive layer RL3 may include the same material as the above-described semiconductor layer AT and may be located in the same layer as the semiconductor layer AT.

The second connecting line CNL2 may be connected to the third resistive layer RL3 through the eighth contact hole H8 defined in the first insulating layer INS1. The second electrode E2 may be connected to the third resistive layer RL3 through the ninth contact hole H9 defined in the first, second, and third insulating layers INS1, INS2, and INS3.

Referring to FIGS. 10 and 23, static electricity may be applied to the above-described connecting pads CPD. When the static electricity flows into the first test elements TS1 through the connecting pads CPD, the third resistive layers RL3 may prevent or reduce the static electricity. Accordingly, damage to the first test elements TS1 may be prevented or reduced.

Referring to FIG. 23, the third resistive layers RL3 may be used together with the first and second resistive layers RL1 and RL2. However, without being limited thereto, the third resistive layers RL3 may be used together the first resistive layers RL1-1 or the second resistive layers RL2-1.

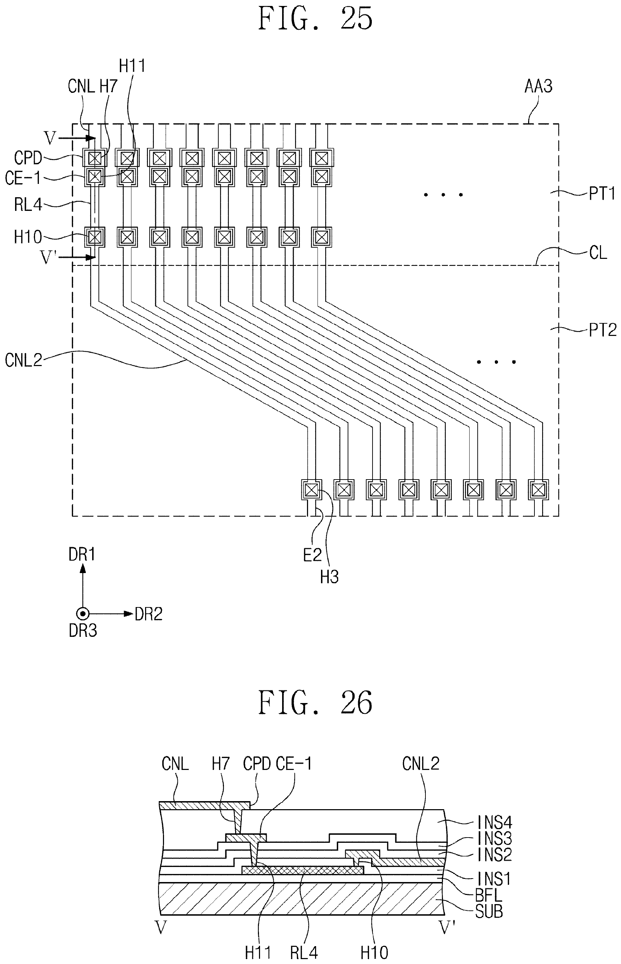

FIG. 25 is a view illustrating a configuration of fourth resistive layers according to some embodiments of the present invention. FIG. 26 is a sectional view taken along the line V-V' illustrated in FIG. 25.

FIG. 25 is a plan view corresponding to FIG. 10. The following description will be focused on components different from the components illustrated in FIG. 10.

Referring to FIG. 25, the test panel TPN may further include a plurality of fourth resistive layers RL4. The second connecting lines CNL2 may be spaced apart from the connecting pads CPD, respectively. The fourth resistive layers RL4 may connect the connecting pads CPD and the second connecting lines CNL2 spaced apart from each other.

The fourth resistive layer RL4 may be connected to the connecting pads CPD and the second connecting lines CNL2 through the connecting electrodes CE-1. The fourth resistive layers RL4 may be connected to the connecting electrodes CE-1 and the second connecting lines CNL2 through tenth and eleventh contact holes H10 and H 11.

The connecting lines CNL may extend from the connecting pads CPD. Ends of the connecting lines CNL may define the connecting pads CPD, respectively.

Referring to FIG. 26, the fourth resistive layer RL4 may be located on the buffer layer BFL, and the second connecting line CNL2 may be located on the first insulating layer INS1. The fourth resistive layer RL4 may include the same material as the above-described semiconductor layer AT and may be located in the same layer as the semiconductor layer AT. The connecting electrode CE-1 may be located on the third insulating layer INS3, and the connecting pad CPD and the connecting line CNL may be located on the fourth insulating layer INS4.

The second connecting line CNL2 may be connected to the fourth resistive layer RL4 through the tenth contact hole H10 defined in the first insulating layer INS1. The connecting electrode CE-1 may be connected to the fourth resistive layer RL4 through the eleventh contact hole H11 defined in the first, second, and third insulating layers INS1, INS2, and INS3. The connecting pad CPD may be connected to the connecting electrode CE-1 through the seventh contact hole H7 defined in the fourth insulating layer INS4.

When static electricity flows into the first test elements TS1 through the connecting pads CPD, the fourth resistive layers RL4 may prevent or reduce the static electricity. Accordingly, damage to the first test elements TS1 may be prevented or reduced.

The fourth resistive layers RL4 may be used together with the first and second resistive layers RL1 and RL2. However, without being limited thereto, the fourth resistive layers RL4 may be used together with the third resistive layers RL3 and the first and second resistive layers RL1 and RL2. Alternatively, the fourth resistive layers RL4 may be used together the first resistive layers RL1-1 or the second resistive layers RL2-1.

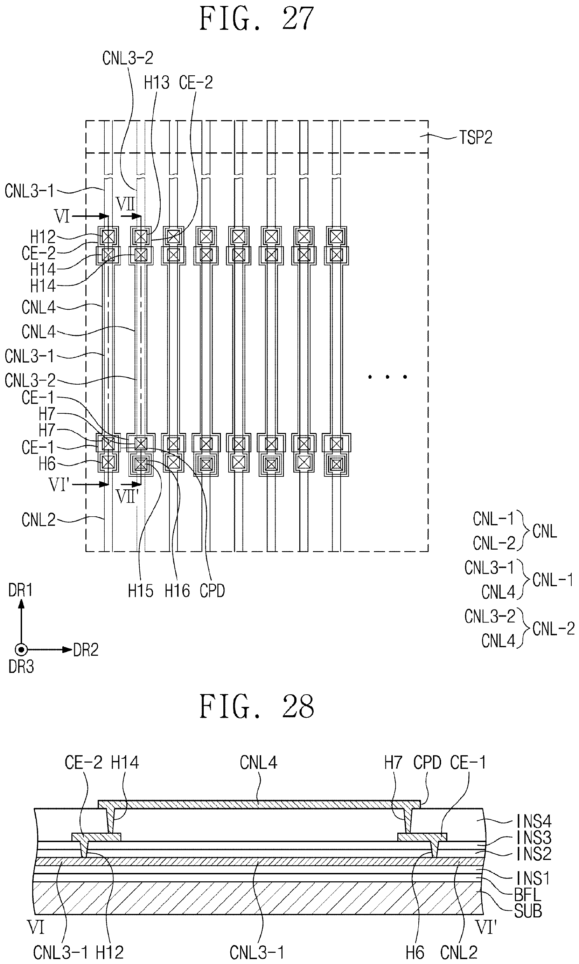

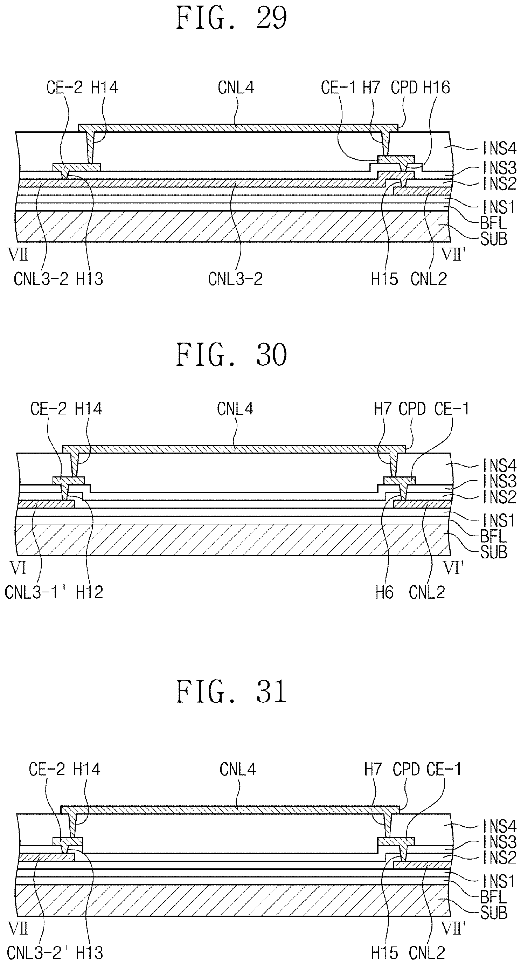

FIG. 27 is a view illustrating a configuration of connecting lines according to some embodiments of the present invention. FIG. 28 is a sectional view taken along the line VI-VI' illustrated in FIG. 27. FIG. 29 is a sectional view taken along the line VII-VII' illustrated in FIG. 27.

The connecting lines CNL illustrated in FIG. 27 may correspond to the connecting lines CNL illustrated in FIG. 1.

Referring to FIG. 27, among the connecting lines CNL, each of odd-numbered connecting lines CNL-1 may include a third connecting line CNL3-1 and a fourth connecting line CNL4. Among the connecting lines CNL, each of even-numbered connecting lines CNL-2 may include a third connecting line CNL3-2 and a fourth connecting line CNL4.

The third connecting lines CNL3-1 and CNL3-2 may extend toward the above-described display region DA and may be connected to the pixels PX through the data lines DL1 to DLn. The fourth connecting lines CNL4 may extend from the connecting pads CPD, respectively.

The fourth connecting lines CNL4 may be connected to the third connecting lines CNL3-1 and CNL3-2, respectively. For example, the fourth connecting lines CNL4 may be connected to the third connecting lines CNL3-1 and CNL3-2 through second connecting electrodes CE-2. The second connecting electrodes CE-2 may be connected to the third connecting lines CNL3-1 and CNL3-2 through twelfth and thirteenth contact holes H12 and H13. The second connecting electrodes CE-2 may be connected to the fourth connecting line CNL4 through fourteenth contact holes H14.

Hereinafter, for convenience of description, a configuration of one odd-numbered connecting line CNL-1 and one even-numbered connecting line CNL-2 will be mainly described.

The third connecting line CNL3-1 of the odd-numbered connecting line CNL-1 may extend toward a corresponding connecting pad CPD and may be connected to a corresponding second connecting line CNL2. Substantially, the third connecting line CNL3-1 may be integrally formed with the corresponding second connecting line CNL2.

The third connecting line CNL3-2 of the even-numbered connecting line CNL-2 may extend toward a corresponding connecting pad CPD and may be connected to a corresponding second connecting line CNL2. The third connecting line CNL3-2 may be connected to the corresponding second connecting line CNL2 through a fifteenth contact hole H15 and may be connected to a corresponding connecting electrode CE-1 through a sixteenth contact hole H16.

Referring to FIG. 28, the third connecting line CNL3-1 may be located on the first insulating layer INS1. The third connecting line CNL3-1 may be located in the same layer as the above-described gate electrode GE. Accordingly, the third connecting line CNL3-1 may be located in the same layer as the second connecting line CNL2. The third connecting line CNL3-1 may extend below the fourth connecting line CNL4 and may be connected to the second connecting line CNL2. For example, on the first insulating layer INS1, the third connecting line CNL3-1 may be integrally formed with the second connecting line CNL2.

The connecting electrodes CE-1 and CE-2 may be located on the third insulating layer INS3, and the connecting pad CPD and the fourth connecting line CNL4 may be located on the fourth insulating layer INS4. The connecting electrode CE-2 may be connected to the third connecting line CNL3-1 through the twelfth contact hole H12 defined in the second and third insulating layers INS2 and INS3. The fourth connecting line CNL4 may be connected to the connecting electrode CE-2 through the fourteenth contact hole H14 defined in the fourth insulating layer INS4.

Referring to FIG. 29, the third connecting line CNL3-2 may be located on the second insulating layer INS2. The third connecting line CNL3-2 may include the same material as the dummy electrode DME illustrated in FIG. 4 and may be located in the same layer as the dummy electrode DME. Accordingly, the third connecting line CNL3-2 may be located in a layer between the above-described gate electrode GE and the second electrode E2.

The third connecting line CNL3-2 may extend below the fourth connecting line CNL4 and may be connected to the second connecting line CNL2. For example, the third connecting line CNL3-2 may be connected to the second connecting line CNL2 through the fifteenth contact hole H15 defined in the second insulating layer INS2.

The connecting electrodes CE-1 and CE-2 may be located on the third insulating layer INS3, and the connecting pad CPD and the fourth connecting line CNL4 may be located on the fourth insulating layer INS4. The connecting electrode CE-2 may be connected to the third connecting line CNL3-2 through the thirteenth contact hole H13 defined in the third insulating layer INS3. The connecting electrode CE-1 may be connected to the third connecting line CNL3-2 through the sixteenth contact hole H16 defined in the third insulating layer INS3.

The third connecting lines CNL3-1 and CNL3-2 may be used together with the above-described first, second, third, or fourth resistive layers RL1, RL2, RL1-1, RL2-1, RL3, or RL4.

FIGS. 30 and 31 are views illustrating third connecting lines having a configuration different from the configuration of the third connecting lines illustrated in FIGS. 28 and 29.

FIGS. 30 and 31 are sectional views corresponding to FIGS. 28 and 29.

Referring to FIGS. 30 and 31, the third connecting lines CNL3-1' and CNL3-2' may be separated from the second connecting line CNL2 and may not be connected to the second connecting line CNL2. The third connecting lines CNL3-1' and CNL3-2' may not extend below the fourth connecting line CNL4.

Referring to FIGS. 28 and 29, when static electricity is applied to the connecting pads CPD, the static electricity may be distributed to both the third connecting lines CNL3-1' and CNL3-2' and the second connecting lines CNL2 with respect to the connecting pads CPD. Accordingly, the intensity of static electricity applied to the first test elements TS1 may be weakened, and thus damage to the first test elements TS1 may be prevented or reduced.

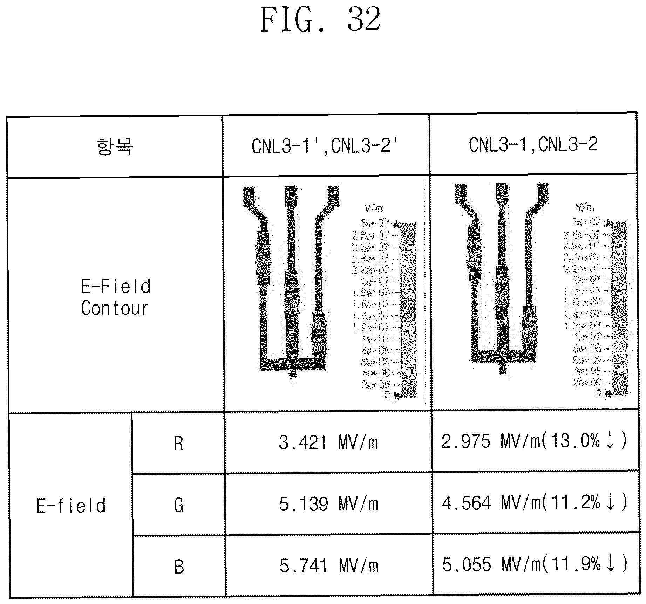

FIG. 32 illustrates test results on electric fields formed on semiconductor layers of first test elements when static electricity is applied to connecting pads in a test panel including the third connecting lines illustrated in FIGS. 28 and 29.

Referring to FIG. 32, when the third connecting lines CNL3-1 and CNL3-2 are used, the intensities of the electric fields may be decreased, as compared with when the third connecting lines CNL3-1' and CNL3-2' illustrated in FIGS. 30 and 31 are used.

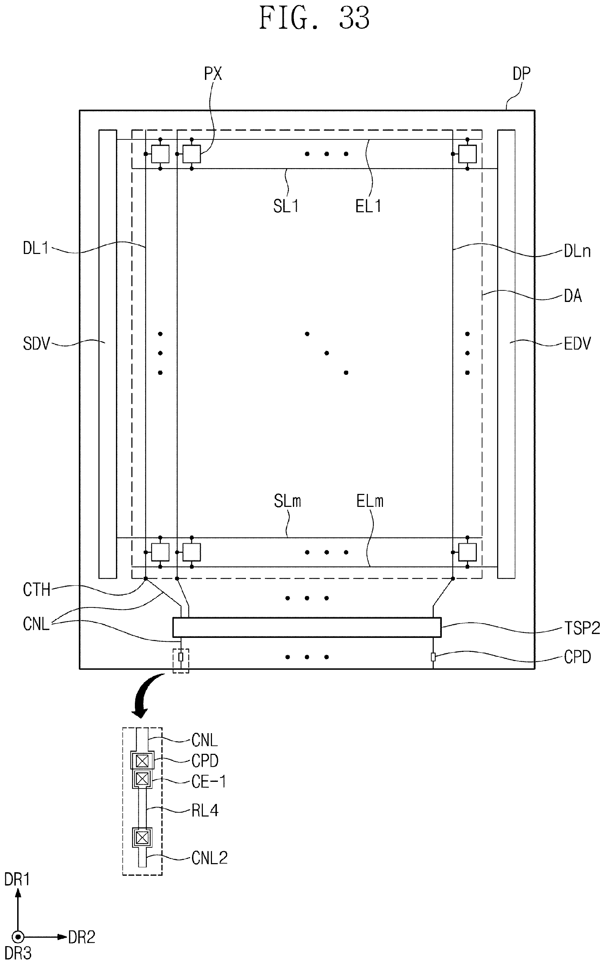

FIG. 33 is a view illustrating the display panel with the second part in FIG. 1 removed.

Referring to FIGS. 25 and 33, when the above-described first, second, third, or fourth resistive layers RL1, RL2, RL1-1, RL2-1, RL3, or RL4 are located in the test panel TPN, the second part PT2 may be removed, and in this case, the fourth resistive layers RL4 may remain in the first part PT1. Accordingly, the display panel DP may include the fourth resistive layers RL4.

The connecting pad CPD defined at one end of the connecting line CNL may be spaced apart from the second test unit TSP2. The fourth resistive layer RL4 may be connected to the connecting pad CPD.

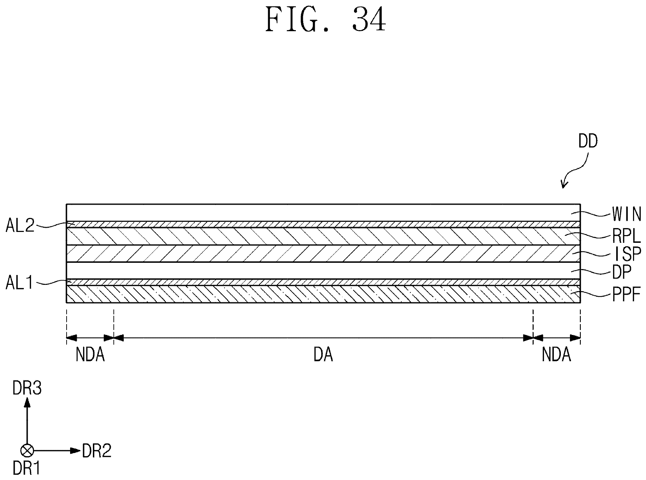

FIG. 34 is a view illustrating a sectional configuration of a display device including the display panel illustrated in FIG. 33.

In FIG. 34, a section of the display device DD viewed in the first direction DR1 is illustrated.

Referring to FIG. 34, the display device DD may include the display panel DP, an input sensing unit ISP, an anti-reflection layer RPL, a window WIN, a panel protection film PPF, and first and second adhesive layers AL1 and AL2. The display device DD may include the above-described fourth resistive layers RL4.

The input sensing unit ISP may be located on the display panel DP. The input sensing unit ISP may include a plurality of sensing units for sensing an external input in a capacitive type. The input sensing unit ISP may be directly manufactured on the display panel DP when the display device DD is manufactured. However, without being limited thereto, the input sensing unit ISP may be manufactured as a panel separate from the display panel DP and may be attached to the display panel DP by an adhesive layer.

The anti-reflection layer RPL may be located on the input sensing unit ISP. The anti-reflection layer RPL may be directly manufactured on the input sensing unit ISP when the display device DD is manufactured. However, without being limited thereto, the anti-reflection layer RPL may be manufactured as a separate panel and may be attached to the input sensing unit ISP by an adhesive layer.

The anti-reflection layer RPL may be defined as a film for preventing or reducing reflection of external light. The anti-reflection layer RPL may decrease the reflectance of external light incident toward the display panel DP from above the display device DD. Due to the anti-reflection layer RPL, the external light may not be visible to a user.

When external light travelling toward the display panel DP is reflected from the display panel DP and provided back to the user, the user may visually recognize the external light as in a mirror. To prevent or reduce such a phenomenon, the anti-reflection layer RPL may include a plurality of color filters that display the same colors as those of the pixels of the display panel DP.

The color filters may filter the external light into the same colors as those of the pixels. In this case, the external light may not be visible to the user. However, without being limited thereto, the anti-reflection layer RPL may include a phase retarder and/or a polarizer to decrease the reflectance of the external light.

The window WIN may be located on the anti-reflection layer RPL. The window WIN may protect the display panel DP, the input sensing unit ISP, and the anti-reflection layer RPL from external scratches and impacts.

The panel protection film PPF may be located under the display panel DP. The panel protection film PPF may protect a lower portion of the display panel DP. The panel protection film PPF may include a flexible plastic material such as polyethylene terephthalate (PET).

The first adhesive layer AL1 may be located between the display panel DP and the panel protection film PPF, and the display panel DP and the panel protection film PPF may be bonded to each other by the first adhesive layer AL1. The second adhesive layer AL2 may be located between the window WIN and the anti-reflection layer RPL, and the window WIN and the anti-reflection layer RPL may be bonded to each other by the second adhesive layer AL2.

According to some embodiments of the present invention, the resistive layers formed of a semiconductive layer may be located adjacent to the first test elements, the test pads, and the connecting pads to prevent or reduce static electricity, thereby preventing or reducing damage to the test elements.

While aspects of some embodiments of the present invention have been described with reference to some embodiments thereof, it will be apparent to those of ordinary skill in the art that various changes and modifications may be made thereto without departing from the scope of embodiments according to the present invention as set forth in the following claims.

## Claims

1. A test panel (TPN) comprising:
a pixel (PX);
a first test element (TS1) connected to the pixel (PX), the first test element (TS1) including a gate electrode (GE), a semiconductor layer (AT), a first electrode (E1), and a second electrode (E2) connected to the pixel (PX);
a test pad (TPD) spaced apart from the first test element (TS1);
a first connecting line (CNL1) connected to the first test element (TS1) and the test pad (TPD); and
a first resistive layer (RL1) in a same layer as the semiconductor layer (AT) and connecting the first electrode (E1) and the first connecting line (CNL1) spaced apart from each other.

2. The test panel (TPN) of claim 1, further comprising:
a second resistive layer (RL2) in the same layer as the semiconductor layer (AT) and connecting the first connecting line (CNL1) and the test pad (TPD) spaced apart from each other.

3. The test panel (TPN) of claim 1 or 2, wherein the first and second resistive layers (RL1, RL2) include a same material as the semiconductor layer (AT).

4. The test panel (TPN) of at least one of claims 1 to 3, wherein the first resistive layer (RL1) and the second resistive layer (RL2) have a same length in an extension direction of each of the first and second resistive layers (RL1, RL2).

5. The test panel (TPN) of at least one of claims 1 to 3, wherein the first resistive layer (RL1) and the second resistive layer (RL2) have different lengths in an extension direction of each of the first and second resistive layers (RL1, RL2).

6. The test panel (TPN) of at least one of claims 1 to 5, wherein the semiconductor layer (AT) and the first and second resistive layers (RL1, RL2) are in a layer below the gate electrode (GE), the first and second electrodes (E1, E2) are in a layer above the gate electrode (GE), and the first connecting line (CNL1) is in a same layer as each of the first and second electrodes (E1, E2).

7. The test panel (TPN) of at least one of claims 1 to 6, wherein the first resistive layer (RL1) is connected to a portion of the first electrode (E1) adjacent to one side of the first electrode (E1) and a portion of the first connecting line (CNL1) adjacent to one side of the first connecting line (CNL1), and the one side of the first electrode (E1) and the one side of the first connecting line (CNL1) face each other, and
wherein the second resistive layer (RL2) is connected to a portion of the first connecting line (CNL1) adjacent to an opposite side of the first connecting line (CNL1) and a portion of the test pad (TPD) adjacent to one side of the test pad (TPD), and the opposite side of the first connecting line (CNL1) and the one side of the test pad (TPD) face each other.

8. The test panel (TPN) of at least one of claims 1 to 7, wherein the test pad (TPD), the first resistive layer (RL1), and the second resistive layer (RL2) extend in a first direction (DR1), and in the first direction (DR1), a length of each of the first and second resistive layers (RL1, RL2) is set to 1/4 to 1/3 of a length of the test panel (TPN).

9. The test panel (TPN) of at least one of claims 1 to 7, wherein the test pad (TPD) and the first resistive layer (RL1) extend in a first direction (DR1), and in the first direction (DR1), a length of the first resistive layer (RL1) is set to 1/3 to 2/3 of a length of the test panel (TPN).

10. The test panel (TPN) of at least one of claims 1 to 7, wherein the test pad (TPD) and the second resistive layer (RL2) extend in a first direction (DR1), and in the first direction (DR1), a length of the second resistive layer (RL2) is set to 1/3 to 2/3 of a length of the test panel (TPN).

11. The test panel (TPN) of at least one of claims 1 to 10, further comprising:
an antistatic circuit (STP) connected to the first connecting line (CNL1), the antistatic circuit (STP) including a plurality of diodes (DO1, DO2).

12. The test panel (TPN) of claim 11, wherein the antistatic circuit (STP) is adjacent to the test pad (TPD).

13. The test panel (TPN) of claim 11 or 12, wherein the first connecting line (CNL1) includes:
a first extension (EXP1) extending from the test pad (TPD) in a first direction (DR1) being an extension direction of the test pad (TPD); and
a second extension (EXP2) extending toward the first test element (TS1) to form an obtuse angle with the first extension (EXP1), and
wherein the antistatic circuit (STP) is connected to the first extension (EXP1) and adjacent to the second extension (EXP2).

14. The test panel (TPN) of at least one of claims 11 to 13, wherein the antistatic circuit (STP) is adjacent to the second resistive layer (RL2).

15. The test panel (TPN) of at least one of claims 1 to 14, further comprising:
a connecting pad (CPD) spaced apart from the second electrode (E2) and connected to the pixel (PX);
a second connecting line (CNL2) connected to the second electrode (E2) and the connecting pad (CPD); and
a third resistive layer (RL3) in the same layer as the semiconductor layer (AT) and connecting the second electrode (E2) and the second connecting line (CNL2) spaced apart from each other.

16. The test panel (TPN) of claim 15, further comprising:
a fourth resistive layer (RL4) in the same layer as the semiconductor layer (AT) and connecting the connecting pad (CPD) and the second connecting line (CNL2) spaced apart from each other.

17. The test panel (TPN) of claim 15 or 16, wherein the second connecting line (CNL2) is in a same layer as the gate electrode (GE), and the connecting pad (CPD) is in a layer above the second electrode (E2).

18. The test panel (TPN) of at least one of claims 1 to 15, further comprising:
a second test element (TS2);
a third connecting line (CNL3) connected to the second test element (TS2) and the pixel (PX); and
a fourth connecting line (CNL4) extending from the connecting pad (CPD) and connected to the third connecting line (CNL3),
wherein the third connecting line (CNL3) extends below the fourth connecting line (CNL4) and is connected to the second connecting line (CNL2).

19. The test panel (TPN) of claim 18, wherein the third connecting line (CNL3) is in a same layer as the second connecting line (CNL2) and integrally formed with the second connecting line (CNL2).

20. The test panel (TPN) of claim 18 or 19, wherein the third connecting line (CNL3) is in a layer between the gate electrode (GE) and the second electrode (E2) and connected to the second connecting line (CNL2).
